# EUROPEAN PATENT SPECIFICATION

(11) **EP 3 401 954 B1**
(45) Date of publication and mention of the grant of the patent: **06.05.2020**
(21) Application number: 16883569.2
(22) Date of filing: 05.01.2016
(51) Int. Cl.: H01L 23/29, H01L 23/28, H01L 23/31, H01L 21/56

(54) **SEMICONDUCTOR DEVICE**
HALBLEITERBAUELEMENT
DISPOSITIF À SEMI-CONDUCTEUR

(43) Date of publication of application: 14.11.2018
(73) Proprietor: Hitachi, Ltd., Tokyo 100-8280 (JP)
(72) Inventor: KOJIMA, Kyoko, Tokyo 100-8280 (JP); YASUI, Kan, Tokyo 100-8280 (JP); YOSHIMOTO, Hiroyuki, Tokyo 100-8280 (JP)
(74) Representative: Mewburn Ellis LLP
(86) International application number: PCT/JP2016/050128
(87) International publication number: WO 2017/119064

(56) References cited:
- JP-A- 2013 191 716
- JP-A- 2013 191 716
- JP-A- 2013 239 488
- JP-A- 2013 239 607
- JP-A- 2013 239 607
- JP-A- 2014 110 277
- JP-A- 2014 236 166
- JP-A- 2014 236 166
- JP-A- 2015 032 665
- JP-A- 2015 032 665

## Description

### Technical Field

The present invention relates to a semiconductor device and relates to, for example, a technology which is effective by applying to the semiconductor device using a wide band gap semiconductor material which is larger than silicon in band gap.

### Background Art

A technology of decreasing intensity of an electric field which generates in a silicone gel from an electric field relaxation region provided in a peripheral region of an SiC element and ensuring stable withstand voltage characteristics is described in Japanese Unexamined Patent Application Publication No. 2013-191718(Patent Literature 1). In this technology, to have an inorganic layer made of silicon oxide and a resin layer formed on an upper part of the inorganic layer between the electric field relaxation region and the silicone gel is described.

A technology of making a radius of curvature of a corner part of a p-type termination region on the [1-1-120] direction side from the center of a semiconductor chip larger than a radius of curvature of a corner part of a p-type termination region on the [11-20] direction side from the center of the semiconductor chip is described in Japanese Unexamined Patent Application Publication No. 2014-236166 (Patent Literature 2).

JP2013191716A discloses a semiconductor device that includes a semiconductor element made from SiC containing an electric field relaxing region at an element upper-surface peripheral part, and a silicon gel which seals the semiconductor element. The semiconductor device includes an inorganic layer of SiO and a resin layer formed on top of the inorganic layer, between the electric field relaxing region and the silicon gel. A dielectric constant of the resin layer is equal to or less than a dielectric constant of the inorganic layer, but equal to or higher than a dielectric constant of the silicon gel.

JP2014110277A discloses a semiconductor element that comprises: a drift layer of a first conductivity type where an active region and a withstanding voltage termination region surrounding the active region in a plan view are formed; and a resin protection film formed on the withstanding voltage termination region. In the withstanding voltage termination region, a plurality of ring-like regions each consisting of a semiconductor layer of a second conductivity type surrounding the active region in a plan view are provided on a surface of the drift layer concentrically via an inter-ring region that is the drift layer between adjacent ring-like regions. The concentrically innermost ring-like region contacts with the active region. A thickness of the resin protection film is larger than a value obtained by dividing the maximum value of a sum of a width of the ring-like region not contacting with the active region and a width of the inter-ring region contacting with the ring-like region by a square root of a dielectric constant of the resin protection film.

JP2013239607A discloses a semiconductor device that comprises: an n-type drift layer formed on an n-type SiC substrate; a Schottky electrode formed on the drift layer; and an anode electrode which is formed on the Schottky electrode and has a width narrower than that of the Schottky electrode. The semiconductor device comprises: a p-type termination region formed on a surface layer part of the drift layer in a region which includes an end of the Schottky electrode; and a resin protection film which covers the end of the Schottky electrode and which has an opening that exposes a top face of the anode electrode and which is formed on the drift layer at an outer periphery. A thickness of the resin protection film on the end of the Schottky electrode is larger than a thickness of the anode electrode.

### Citation List

### Patent Literature

Patent Literature 1: Japanese Unexamined Patent Application Publication No. 2013-191718
Patent Literature 2: Japanese Unexamined Patent Application Publication No. 2014-236166

### Summary of Invention

### Technical Problem

For example, the wide band gap semiconductor material which is larger than silicon in band gap is high in dielectric breakdown electric field intensity and therefore allows a design which increases electric field intensity in the semiconductor chip, and it is possible to promote a reduction in manufacturing cost by reducing an electric field relaxation part (a termination part) formed on a peripheral edge part of the semiconductor chip.

Here, since also the intensity of an electric field which is imposed on a sealing body which is in contact with the wide band gap semiconductor material is increased, a sealing material for the wide band gap semiconductor material is requested to be high in dielectric breakdown intensity. For example, in a case of silicon, a part just above the electric field relaxation part is sealed with a sealing member such as the silicone gel and so forth. However, in a case of the wide band gap semiconductor material, since the electric field intensity exceeds dielectric breakdown electric field intensity of the silicone gel, insertion of an insulating member between the electric field relaxation part and the silicone gel is examined.

At this time, for example, after acquiring a semiconductor chip by dicing a semiconductor wafer, formation of an insulating member is performed in the course of loading the semiconductor chip on an insulated substrate. That is, pinpoint dropping of the insulating member is performed onto the electric field relaxation part which is formed on a peripheral edge part of the semiconductor chip. However, in this case, a shape of an outer end part of the insulating member is formed into a hem-trailing tapered shape caused by the pinpoint dropping technology. From this, it is feared that a film thickness of the insulating member may be thinned in the vicinity of an outer end part of the semiconductor chip and it may become impossible to sufficiently relax the electric field intensity.

On this point, although it is possible to relax the intensity of the electric field on the vicinity of the outer end part of the semiconductor chip by designing a width of the electric field relaxation part sufficiently large, in this case, the size of the electric field relaxation part which does not function as a semiconductor element formation part is increased and an increase in manufacturing cost is induced.

Therefore, it is desired to contrive the shape of the insulating member in such a manner that relaxation of the intensity of the electric field on the vicinity of the outer end part of the semiconductor chip is possible even when the field relaxation part is reduced in order to effectively make use of material with excellent physical properties of the wide band gap semiconductor material.

An object of the present invention is to improve reliability of the semiconductor device by realizing a structure which relaxes the intensity of the electric field on the vicinity of the outer end part of the semiconductor chip in the semiconductor device using the wide band gap semiconductor material which is larger than silicon in band gap.

Other issues to be solved and novel features will become apparent from description of the present specification and appended drawings. Solution to Problem

According to the present invention there is provided a semiconductor device as specified in claim 1.

The semiconductor device of the present invention may optionally be as specified in any one of claims 2 to 6.

### Advantageous Effect of the Invention

According to one embodiment, it is possible to improve the reliability of the semiconductor device.

### Brief Description of Drawings

Fig. 1 is a block diagram illustrating one example of a three-phase motor system applied to a railway vehicle.
Fig. 2 is a circuit diagram illustrating a circuit configuration of a converter and an inverter.
Fig. 3 is a plan view illustrating a schematic configuration of a semiconductor chip with a diode formed in related art.
Fig. 4 is a sectional diagram cut along the A-A line in Fig. 3.
Fig. 5 is a diagram schematically illustrating a forming process of a high electric field resistance sealing member.
Fig. 6 is a sectional diagram illustrating a configuration of a semiconductor device in the related art.
Fig. 7 is a sectional diagram schematically illustrating a semiconductor device in a first embodiment, not forming part of the invention but useful for understanding it.
Fig. 8 is a flowchart illustrating a flow of a manufacturing process of the semiconductor device in the first embodiment.
Fig. 9 is a diagram illustrating a situation where the high electric field resistance sealing member is applied onto a semiconductor wafer.
Fig. 10 is a diagram illustrating part of the semiconductor wafer in an enlarged state.
Fig. 11 is a sectional diagram illustrating a situation where the high electric field resistance sealing member is dropped from a dispenser to cover a termination part formed on the semiconductor wafer.
Fig. 12 is a diagram illustrating a process of cutting the semiconductor wafer along a scribe line on the semiconductor wafer.
Fig. 13 is a sectional diagram illustrating the process of cutting the semiconductor wafer.
Fig. 14 is a sectional diagram illustrating a state after cutting the semiconductor wafer.
Fig. 15 is a sectional diagram illustrating the vicinity of an end part of a semiconductor chip in the first embodiment in the enlarged state.
Fig. 16 is a diagram illustrating a shape that part of an outer end part of the high electric field resistance sealing member is formed into an inclined shape.
Fig. 17 is a diagram illustrating a shape that the part of the outer end part of the high electric field resistance sealing member is formed into a projected shape.
Fig. 18 is a plan view illustrating a semiconductor chip in the related art.
Fig. 19 is a diagram describing the definition of the "radius of curvature" in the first embodiment, not forming part of the invention but useful for understanding it.
Fig. 20(a) is a schematic diagram illustrating one planar configuration of the semiconductor chip in the first embodiment according to the present invention and Fig. 20(b) is a schematic diagram illustrating another planar configuration example thereof.
Fig. 21 is a diagram describing a forming process of the high electric field resistance sealing member.
Fig. 22 is a diagram describing the forming process of the high electric field resistance sealing member.
Fig. 23 is a diagram schematically illustrating the high electric field resistance sealing member thermoset by a predetermined temperature sequence.
Fig. 24(a) is a schematic diagram illustrating one planar configuration of a semiconductor chip in a first modified example according to the present invention and Fig. 24(b) is a schematic diagram illustrating another planar configuration example thereof.
Fig. 25 is a diagram describing a forming process of the high electric field resistance sealing member.
Fig. 26 is a diagram describing the forming process of the high electric field resistance sealing member.
Fig. 27(a) is a schematic diagram illustrating one planar configuration of a semiconductor chip in a second modified example according to the present invention and Fig. 27(b) is a schematic diagram illustrating another planar configuration example thereof.
Fig. 28(a) is a schematic diagram illustrating a state where a connection part with a wire is formed in one planar configuration example of the semiconductor chip in the second modified example and Fig. 28 (b) is a schematic diagram illustrating a state where the connection part with the wire is formed in another planar configuration example thereof.
Fig. 29 is a diagram describing a forming process of the high electric field resistance sealing member.
Fig. 30 is a diagram describing the forming process of the high electric field resistance sealing member.
Fig. 31 is a diagram illustrating a specific numerical value example of each parameter for each of a plurality of chips defined in each parameter.
Fig. 32 is a schematic diagram illustrating a configuration of a semiconductor module in the first embodiment, not forming part of the invention but useful for understanding it.
Fig. 33 is a schematic diagram illustrating the configuration of the semiconductor module in the first embodiment, not forming part of the invention but useful for understanding it.
Fig. 34 is a schematic diagram illustrating a planar configuration example of an insulated substrate in the first embodiment, not forming part of the invention but useful for understanding it.
Fig. 35 is a diagram illustrating a planar configuration of a semiconductor chip with an SiC-MOSFET formed, not forming part of the invention but useful for understanding it.
Fig. 36 is a diagram illustrating a semiconductor chip of a planar configuration that a gate pad is disposed in the vicinity of an end part of a source pad, not forming part of the invention but useful for understanding it.
Fig. 37(a) is a schematic diagram illustrating one planar configuration of a semiconductor chip in a second embodiment according to the present invention and Fig. 37(b) is a schematic diagram illustrating another planar configuration example thereof.
Fig. 38(a) is a schematic diagram illustrating another planar configuration of the semiconductor chip in the second embodiment according to the present invention and Fig. 38 (b) is a schematic diagram illustrating another planar configuration example thereof.
Fig. 39 is a schematic diagram illustrating a planar configuration example of an insulated substrate in the second embodiment, not forming part of the invention but useful for understanding it.

### Description of Embodiments

Although, in the following embodiments, description will be made by dividing it into a plurality of sections or embodiments when necessary for convenience, these are not unelated to each other or one another and these are related to each other or one another in such a manner that one covers some or all of modified examples, the details, supplemental explanations and so forth of the other except where clearly stated particularly.

In addition, in the following embodiments, in a case where the number of elements and so forth (the number of units, a numerical value, an amount/a quantity, a range and so forth are included) is referred to, it is not limited to the specific number and may be either at least the specific number or not more than the specific number except where clearly stated particularly and except where obviously limited to the specific number in principle and so forth.

Further, in the following embodiments, it goes without saying that the constitutional elements (element steps and so forth are also included) thereof are not necessarily essential except where clearly stated particularly and except where clearly thought to be essential in principle.

Likewise, in the following embodiments, when the shapes of the constitutional elements and so forth, a positional relationship between/among them and so forth are referred to, the ones which are substantially approximate to or similar to the shapes and so forth shall be included except where clearly stated particularly and except where clearly thought that they are not approximate or similar thereto in principle. The same is true of the above-mentioned numerical values and ranges.

In addition, in all the drawings illustrated for description of the embodiments, the same numerals are assigned to the same members in principle and repetitive description thereof is omitted. Incidentally, there are cases where hatching is added even in a plan view for clear illustration of the drawings.

### (First Embodiment)

### <Configuration Example of Three-Phase Motor System>

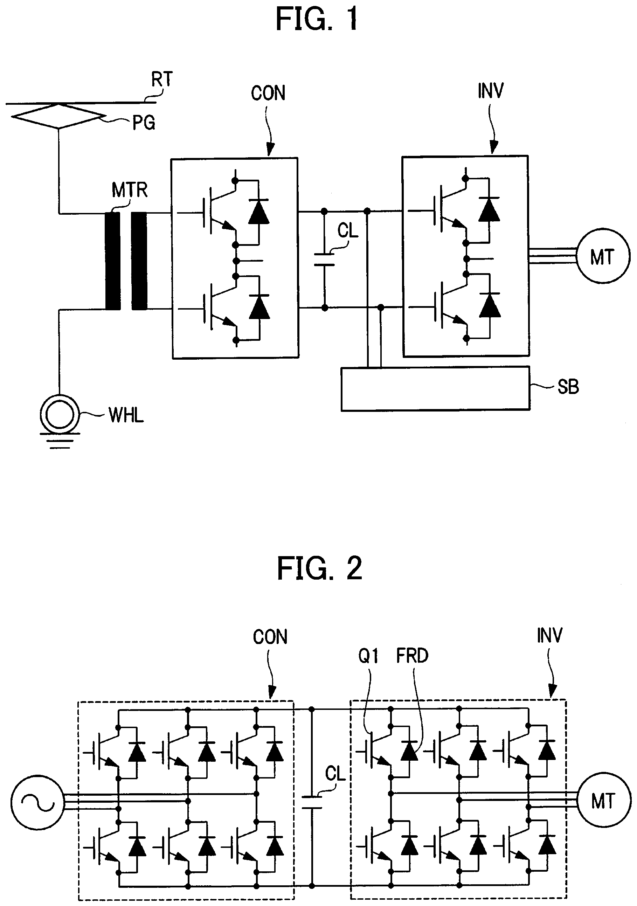

Fig. 1 is a block diagram illustrating one example of, for example, a three-phase motor system (a power conversion device) applied to a railway vehicle. As illustrated in Fig. 1, electric power is suppled from an overhead line RT to the railway vehicle via a pantograph PG. At this time, a high DC voltage which is supplied from the overhead line RT is, for example, 25 kV or 15 kV. The high DC voltage which is supplied from the overhead line RT to the railway vehicle via the pantograph PG is dropped by an insulation-type main transformer MTR to an AC voltage of, for example, 3.3 kV. The dropped AC voltage is forward-converted to a DC voltage (3.3 kV) by a converter CON. Thereafter, the DC voltage so converted by the converter CON is converted into AC voltages of three phases which are 120 degrees out-of- phase by an inverter INV via a capacitor CL. Then, the three-phase AC voltages so converted by the inverter INV are supplied to a three-phase motor MT. Consequently, the three-phase motor MT is driven and thereby it is possible to rotate wheels WHL, and thereby it is possible to make the railway vehicle run.

In this way, the converter CON and the inverter INV are included in the three-phase motor system of the railway vehicle. Fig. 2 is a circuit diagram illustrating a circuit configuration of the converter CON and the inverter INV illustrated in Fig. 1. As illustrated in Fig. 2, each of the converter CON and the inverter INV is configured by six power transistors Q1 and six free wheel diodes FRD. For example, when focusing on the inverter INV, an upper arm (a high-side switch) and a lower arm (a low-side switch) are provided in correspondence with each of the three phases (a U-phase, a V-phase and a W-phase). Each of the upper arm and the lower arm is configured by one power transistor Q1 and one free wheel diode FRD which are connected in parallel with each other. At this time, while the power transistor Q1 functions as a switching element, the free wheel diode functions as, for example, a rectification element which makes a reflux current caused by an inductance included in the three-phase motor MT flow.

As described above, power semiconductor elements such as the power transistor Q1, the free wheel diode FRD and so forth are used as main constituent components having a switching function and a rectifying function in power conversion equipment such as the inverter INV, the converter CON and so forth. For example, an IGBT (Insulated Gate Bipolar Transistor) which uses silicon (Si) as a substrate material thereof is used as the power transistor Q1 and a p-n junction diode which uses silicon as the substrate material thereof is used as the free wheel diode FRD.

On this point, in recent years, use of a wide band gap semiconductor material which is larger than silicon in band gap as the substrate material of the power semiconductor element is examined and development of the power semiconductor element using this wide band gap semiconductor material is promoted. This is because the wide band gap semiconductor material is higher than silicon in dielectric breakdown electric field intensity owing to the band gap thereof which is larger than that of silicon. That is, since, in the power semiconductor element using the wide band gap semiconductor material, the dielectric breakdown electric field intensity thereof is higher than that of silicon, it is possible to secure a withstand voltage even when a thickness of a drift layer (an epitaxial layer) is made thinner than that in the power semiconductor element which uses silicon as the substrate material. Further, it is possible to promote a reduction in on-resistance by thinning the thickness of the drift layer in the power semiconductor element using the wide band gap semiconductor material. That is, an advantage that it is possible to promote simultaneous attainment of insurance of the withstand voltage and the reduction in on-resistance which are in a trade-off relation is obtained in the power semiconductor element using the wide band gap semiconductor material as the substrate material.

Although as the wide band gap semiconductor material, for example, silicon carbide (SiC), gallium nitride (GaN), diamond and so forth may be given, in the following, description will be made focusing on SiC particularly.

SiC which is the wide band gap semiconductor material is about one digit higher than silicon in dielectric breakdown electric field intensity and therefore makes on-resistance reduction of the power semiconductor element possible. This is because, as described above, when the dielectric breakdown electric field intensity is high, it is possible to secure the withstand voltage even with the thin drift layer (the epitaxial layer) and consequently it is possible to promote the on-resistance reduction by thinning the drift layer. Further, since heat conductivity of SiC is about three times heat conductivity of silicon and it is excellent in semiconductor physical properties even at a high temperature, it is suited for high-temperature use.

Accordingly, in recent years, replacement of the power semiconductor element which uses silicon as the substrate material with the power semiconductor element which uses SiC as the substrate material is examined. Specifically, when giving the inverter INV by way of example, as the free wheel diode FRD which is the rectification element in the switching element and the rectification element which are constituent components of the inverter INV, development of replacement of the p-n junction diode which uses silicon as the substrate material with a Schottky barrier diode which uses SiC as the substrate material (in the following, called an SiC Schottky barrier diode) takes precedence.

In this way, in a case where the p-n junction diode which uses silicon as the substrate material is replaced with the SiC Schottky barrier diode, it is reported that there is no recovery current in the Schottky barrier diode and therefore it is possible to reduce a switching loss to 1/10. This is because while in the p-n junction diode which is a bipolar element, a small number of carriers which are accumulated when switching flow as the recovery current, there is no accumulation of the small number of carriers in the Schottky barrier diode which is a unipolar element.

In addition, also in the switching element in addition to the rectifying element, as the power transistor Q1 which is the switching element, replacement of the IGBT which uses silicon as the substrate material (in the following, called an Si-IGBT) with a MOSFET (Metal Oxide Semiconductor Field Effect Transistor) which uses SiC as the substrate material (in the following, called an SiC-MOSFET) is also examined. This is because it is possible to increase a switching loss reduction effect by replacing the Si-IGBT with the SiC-MOSFET. This is because it is possible to reduce the switching loss by replacing the Si-IGBT which is the bipolar element with the SiC-MOSFET which is the unipolar element according to the principle which is the same as that in a case where the p-n junction diode made of silicon is replaced with the SiC Schottky barrier diode. Incidentally, in a case where the power transistor Q1 of the inverter INV is configured by the SiC-MOSFET, a body diode is formed parasitically in the SiC-MOSFET and this body diode functions as the free wheel diode FRD. From this, it becomes also possible to omit the Schottky barrier diode which functions as the free wheel diode FRD.

Incidentally, although it is possible to manufacture the Schottky barrier diode and the MOSFET also by using silicon, it is necessary to thicken the thickness of the drift layer in order to increase the withstand voltage, and thereby the on-resistance is increased and thus usage of silicon is not practical. That is, it becomes possible to secure the withstand voltage with the thin drift layer only when SiC which is high in dielectric breakdown electric field intensity is used and thereby it becomes possible to promote simultaneous attainment of the assurance of the withstand voltage and the reduction in on-resistance. That is, it becomes possible to apply the Schottky barrier diode and the MOSFET which are the unipolar elements even to a high withstand voltage region of 600 V to 6.5 kV in withstand voltage application of the existing Schottky barrier diode and MOSFET which are made of silicon to which was not possible precisely because low-resistance SiC which makes it possible to secure the withstand voltage with the thin drift layer is used.

Further, as the power transistor Q1 which is the switching element, replacement of the Si-IGBT with an IGBT which uses SiC as the substrate material (in the following, called an SiC-IGBT) is also examined. This is because, since the SiC-IGBT makes it possible to increase an amount of driving current for the three-phase motor (a load) in comparison with the SiC-MOSFET which is the same as that in withstand voltage and is high in withstand voltage per device in comparison with the Si-IGBT, it is possible to reduce the number of components. Consequently, it is possible to reduce the size (the volume) of the three-phase motor system. This makes it possible to promote floor-lowering of the railway vehicle by miniaturizing, for example, under-floor components including the three-phase motor system. In addition, since it is possible to secure a space which makes new installation of a storage battery SB (see Fig. 1) possible in part of the railway vehicle by miniaturization of the under-floor components, in a case where the railway vehicle does not run, it is possible to store the electric power in the storage battery SB without returning the electric power to the overhead line RT via the wheels WHL. Consequently, it is possible to improve regeneration efficiency of the railway vehicle. In other words, it is possible to reduce a life cycle cost of a railway system.

### <Structure Peculiar to SiC Device>

As described above, in the power semiconductor element which uses SiC as the substrate material (in the following, called an SiC device), a design that the electric field intensity in a semiconductor chip on which the SiC device is formed is enhanced becomes possible owing to the high dielectric breakdown electric field intensity of SiC. That is, the SiC device has a structure which is peculiar to the SiC device in order to realize the design that the electric field intensity in the semiconductor chip is enhanced. In the following, the structure peculiar to the SiC device will be described.

As described above, SiC is high in dielectric breakdown electric field intensity and therefore makes the design that the electric field intensity in the semiconductor chip is enhanced possible, and it is possible to realize cost reduction of the semiconductor chip by decreasing the size of an electric field relaxation part (a termination part) which is formed on a peripheral edge part of the semiconductor chip. In this case, since also the intensity of the electric field imposed on a sealing member which is in contact with the semiconductor chip is enhanced, the sealing member which is used for sealing the semiconductor chip with the SiC device formed is requested to be high in dielectric breakdown electric field intensity. For example, while in a semiconductor chip with a silicon device formed, the semiconductor chip is sealed with the sealing member such as a silicone gel and so forth, in the semiconductor chip with the SiC device formed, the intensity of the electric field imposed on the sealing member exceeds the dielectric breakdown electric field intensity of the silicone gel and therefore a contrivance is necessary. That is, in the semiconductor chip with the SiC device formed, insertion of a high electric field resistance sealing member which is higher than the silicone gel in dielectric breakdown electric field intensity between the peripheral edge part of the semiconductor chip and the silicone gel is performed. That is, the structure peculiar to the SiC device which is described here is a structure that the high electric field resistance sealing member is inserted between the semiconductor chip with the SiC device formed and the silicone gel. According to this structure, it becomes possible to suppress the intensity of the electric field in the silicone gel within an allowable range by inserting the high electric field resistance sealing member in the vicinity of the peripheral edge part of the semiconductor chip with the SiC device formed and consequently it is possible to improve reliability of a semiconductor device which includes the semiconductor chip with the SiC device formed.

In this way, although in the semiconductor chip with the SiC device formed, it has the structure which is peculiar to the SiC device, according to examinations made by the present inventers, it is clarified that there is still room for new improvement regarding the structure peculiar to the SiC device. Then, in the following, knowledge regarding the room for new improvement that the present inventers have found will be described.

### <Examination of Improvement>

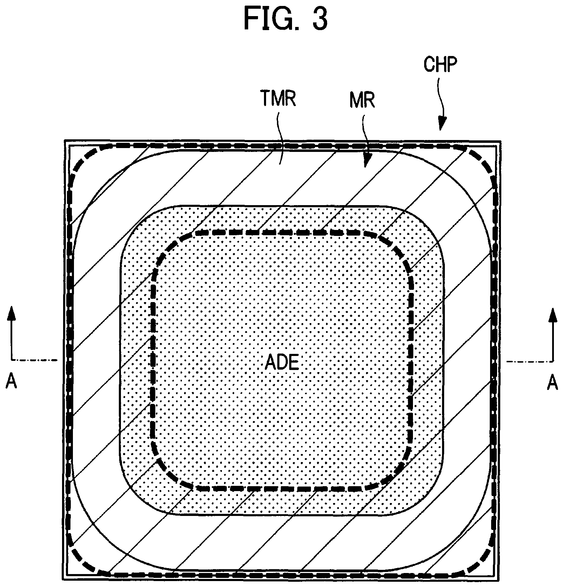

In the following, the improvement will be examined by giving the diode as one example of the SiC device. Fig. 3 is a plan view illustrating a schematic configuration of a semiconductor chip CHP with the diode formed in related art. As illustrated in Fig. 3, an anode electrode (an anode electrode pad) ADE is formed on a central part of the rectangular semiconductor chip CHP and a termination part TMR which functions as the electric field relaxation part is formed to planarly surround the anode electrode ADE. Then, a high electric field resistance sealing member MR is formed to cover the termination part TMR. Incidentally, the "related art" described in the present specification is art having an issue that the inventers have newly found and, though not well-known prior art, is the art which is described intending for a technical premise (unknown art) of a novel technical idea.

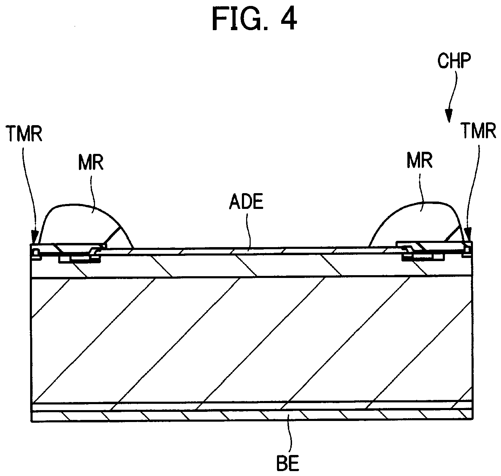

Fig. 4 is a sectional diagram cut along the A-A line in Fig. 3. As illustrated in Fig. 4, while a back-face electrode which functions as a cathode electrode is formed on a back face of the semiconductor chip CHP, the anode electrode ADE is formed on a front face of the semiconductor chip CHP. Then, the termination part TMR is formed to sandwich the anode electrode ADE and the high electric field resistance sealing part MR is formed over a region which strides over the anode electrode ADE from above the termination part TMR. Here, since the room for improvement that the preset inventers have found is present in the shape of this high electric field resistance sealing member MR and is particularly caused by a manufacturing process of the high electric field resistance sealing member MR in the related art, in the following, the manufacturing process of the high electric field resistance sealing member MR in the related art will be briefly described.

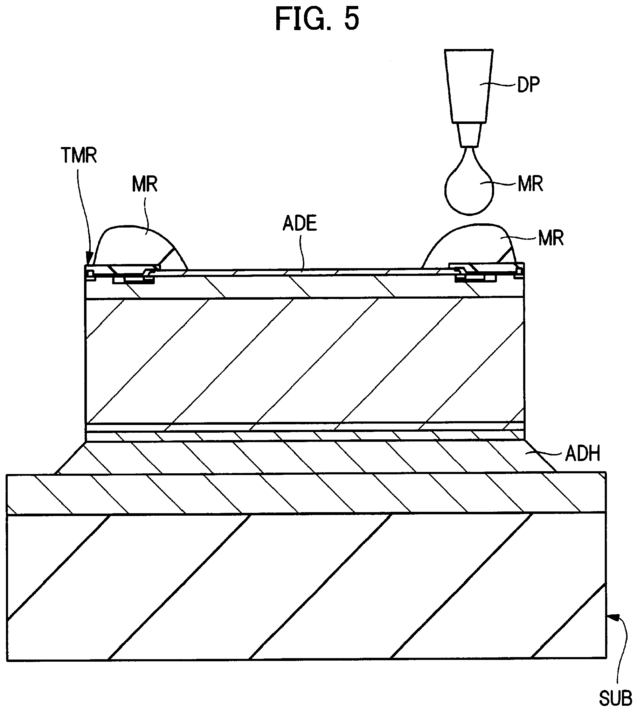

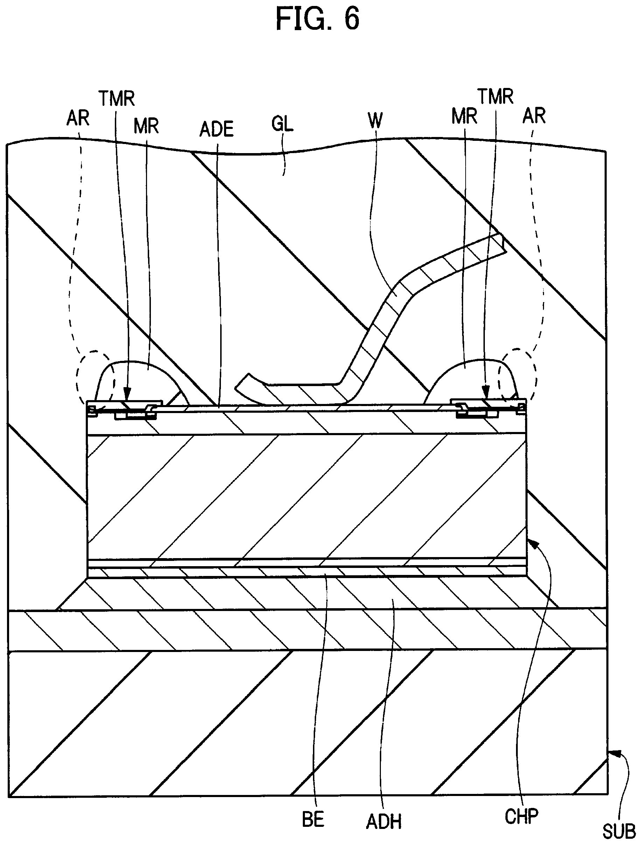

Specifically, in the related art, a semiconductor wafer is diced and segmented into the plurality of semiconductor chips and thereafter the high electric field resistance sealing member MR is formed in a state where the respective semiconductor chips are loaded on an insulated substrate. Fig. 5 is a diagram schematically illustrating a forming process of the high electric field resistance sealing member MR. In Fig. 5, the semiconductor chip CHP is loaded on an insulated substrate SUB with a soldering material (an adhesive material) ADH and thereafter the high electric field resistance sealing member MR is formed over the region which strides over the anode electrode ADE from above the termination part TMR by dropping the high electric field resistance sealing member MR which is in a paste state from a dispenser DP. Thereafter, as illustrated in Fig. 6, a wire W is connected to the anode electrode ADE which is formed on the front face of the semiconductor chip CHP and a silicone gel GL which is a sealing member is formed to cover the semiconductor chip CHP. At this time, in Fig. 6, as illustrated by a region AR, the shape of an outer end part of the high electric filed resistance sealing member MR is formed into a hem-trailing tapered shape caused by a forming method in an application technology (a potting technology) performed after formation of the semiconductor chip illustrated in Fig. 5. Consequently, the present inventers have newly found that, as illustrated in Fig. 6, a film thickness of the high electric field resistance sealing member MR is thinned in the vicinity of the outer end part of the high electric field resistance sealing member MR and thereby it is not possible to sufficiently relax the electric field in the vicinity of an outer edge part of the semiconductor chip CHP. That is, the knowledge that the present inventers have newly found is knowledge that in the method of applying the pasted high electric field resistance sealing member MR onto the vicinity of the outer edge part of the semiconductor chip CHP by a potting method for the fragmented semiconductor chips CHP as in the related art, the film thickness of the outer end part of the high electric field resistance sealing member MR is thinned and it is not possible to sufficiently relax the electric field in this region. Consequently, an electric field whose intensity is more than the dielectric breakdown electric field intensity is imposed on the silicone gel and the reliability of the semiconductor device is lowered.

On this point, it is possible to relax the electric field in the vicinity of the outer edge part of the semiconductor chip CHP by designing the width of the termination part TMR which is formed on a lower layer of the high electric field resistance sealing member MR sufficiently large. However, in this case, as a result of increasing the size of the termination part TMR which seldom contributes to electrical conduction on the semiconductor chip CHP using expensive SiC, the manufacturing cost of the SiC device is increased. For effective utilization of the excellent material physical properties of SiC, it is necessary to contrive the shape of the high electric field resistance sealing member MR in such a manner that it is possible to relax the electric field in the vicinity of the outer end part of the semiconductor chip CHP irrespective of size reduction of the termination part TMR.

Further, according to the examinations made by the present inventers, there is room for new improvement in the related art. That is, in the related art, the forming process of the high electric field resistance sealing member MR is performed after loading the fragmented semiconductor chip CHP on the insulated substrate SUB, for example, as illustrated in Fig. 5. Specifically, as illustrated in Fig. 5, the high electric field resistance sealing member MR is applied by the dispenser DP to make one cycle along the termination part TMR of the semiconductor chip CHP which is loaded on the insulated substrate SUB via the soldering material ADH. In this application method, it is necessary to repetitively perform application onto all the semiconductor chips CHP loaded on the insulated substrate SUB while aligning horizontal positions and heights of application nozzles for every semiconductor chip CHP loaded on the insulated substrate SUB and time is taken for the manufacturing process. Further, after application of the pasted high electric field resistance sealing member MR, a thermosetting process of the high electric field resistance sealing member MR is necessary and, in the thermosetting process, it is necessary to heat-treat the insulated substrate SUB for several hours. In addition, although the semiconductor chip CHP is soldered to the insulated substrate SUB with the soldering material ADH, the soldering material ADH is liquefied in reflow and a variation in thickness and movement and rotation in a horizontal direction occur. Therefore, minute alignment deviation occurs in each of the plurality of semiconductor chips CHP loaded on the insulated substrate SUB. On this point, although the dispenser DP has a function of optically recognizing positions of the semiconductor chips CHP and performing correction, application accuracy of the high electric field resistance sealing member MR is liable to be lowered and there exists a trade-off relation that when improvement of the application accuracy of the high electric field resistance sealing member MR is promoted, application time is increased.

In this way, the present inventers newly find the room for improvement which is present in the related art and make a contrivance to the room for improvement. In the following, the technical idea in the present first embodiment that this contrivance is made will be described. In particular, since the technical idea in the present first embodiment has a technical idea on a sectional view point and a technical idea on a planar view point, first, the technical idea focusing on the sectional view point will be described and then the technical idea focusing on the planar view point will be described.

### 1. Technical Idea Focusing on Section

### <Configuration of Semiconductor Device>

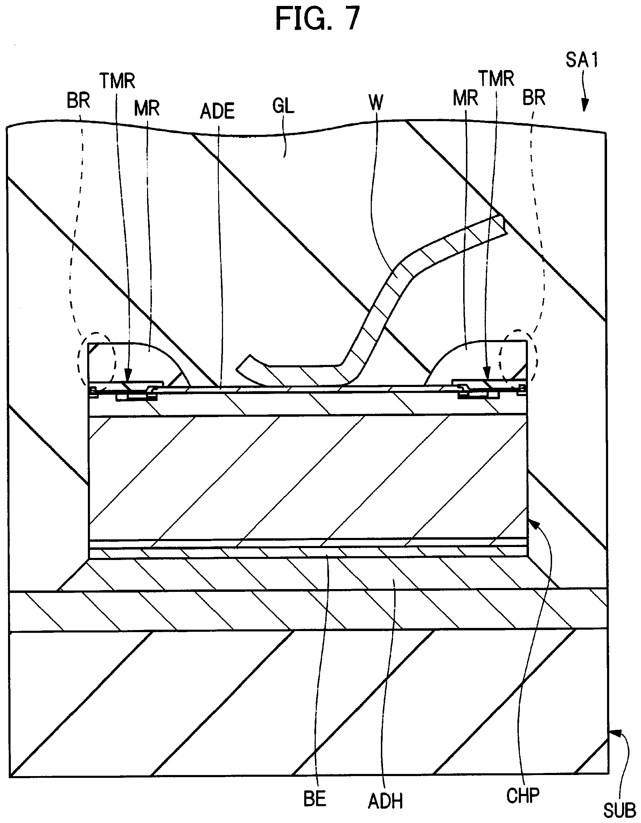

Fig. 7 is a sectional diagram schematically illustrating a semiconductor device SA1 in the present first embodiment, not forming part of the invention but useful for understanding it. As illustrated in Fig. 7, a semiconductor chip CHP1 is loaded on the insulated substrate SUB via the soldering material ADH. The SiC device is formed on this semiconductor chip CHP1 and the diode is given as the SiC device in the present first embodiment particularly.

In Fig. 7, a back-face electrode BE which functions as a cathode electrode of the diode is formed on a back face of the semiconductor chip CHP1. On the other hand, a front face of the semiconductor chip CHP1 is an element formation face. The anode electrode ADE of the diode is formed on the front face of the semiconductor chip CHP1 and the termination part TMR is formed to surround the anode electrode ADE. The termination part TMR is formed over a peripheral edge part of the semiconductor chip CHP1 and is formed for the purpose of relaxing the strength of the electric field on the peripheral edge part of the semiconductor chip CHP1. The diode which is the SiC device is formed on the inner side of the termination part TMR. That is, the semiconductor chip CHP1 in the present first embodiment has a semiconductor element formation part that the diode is formed on the inner side of the peripheral edge part on which the termination part TMR is formed. Then, the high electric field resistance sealing member MR is formed to cover the termination part TMR which is formed on the peripheral edge part of the semiconductor chip CHP1 and to cover the vicinity of an end part of the anode electrode ADE. In addition, the wire W is connected to the vicinity of a central part of the anode electrode ADE. The semiconductor chip CHP1 so configured is sealed with the silicone gel GL which is the sealing member. Here, the dielectric breakdown electric field intensity of the high electric field resistance sealing member MR becomes larger than the dielectric breakdown electric field intensity of the silicone gel GL which is the sealing member. In addition, the high electric field resistance sealing member MR is formed to cover only the vicinity of the peripheral edge part of the semiconductor chip CHP1 and is smaller in size than the silicone gel GL which is formed to cover the semiconductor chip CHP1. That is, a volume of the high electric field resistance sealing member MR is made smaller than a volume of the silicone gel GL which is the sealing member.

Here, in the semiconductor device SA1 in the present first embodiment, for example, as illustrated in Fig. 7, the high electric field resistance sealing member MR is in direct contact with the silicone gel GL. In other words, the high electric field resistance sealing member MR is interposed between the termination part TMR which is formed on the peripheral edge part of the semiconductor chip CHP1 and the silicone gel GL. That is, an upper face of the termination part TMR is covered with the high electric field resistance sealing member MR and the termination part TMR is not in direct contact with the silicone gel GL.

As described above, the semiconductor device SA1 in the present first embodiment contains the semiconductor material which is larger than silicon in band gap (silicon carbide, gallium nitride, diamond and so forth) and is equipped with the semiconductor chip CHP1 having the high electric field resistance sealing member MR (an insulating member) which covers the peripheral edge part of the element formation face and the silicone gel GL which is the sealing member for covering the semiconductor chip CHP1. Then, as illustrated in FIG. 7, an end face of the semiconductor chip CHP1 and an outer end face of the high electric field resistance sealing member MR include parts which are flush with each other. For example, the high electric field resistance sealing member MR in the present first embodiment has a shape that a thickness of the outer end part of the high electric field resistance sealing member MR is thicker than thicknesses of other parts of the high electric field resistance sealing member MR. The high electric field resistance sealing member MR is configured by a material which is higher than the silicone gel GL in dielectric breakdown electric field intensity and may be configured by any of, for example, a polyimide resin, a polyamide-imide resin, a polyether-amide-imide resin and a polyether-amide resin.

### <Manufacturing Method of Semiconductor Device>

The semiconductor device SA1 in the present first embodiment is configured as described above. In the following, a manufacturing method thereof will be described with reference to the drawings . First, a flow of a manufacturing process of the semiconductor device SA1 in the present first embodiment will be described and thereafter details of the manufacturing process will be described with reference to a flowchart.

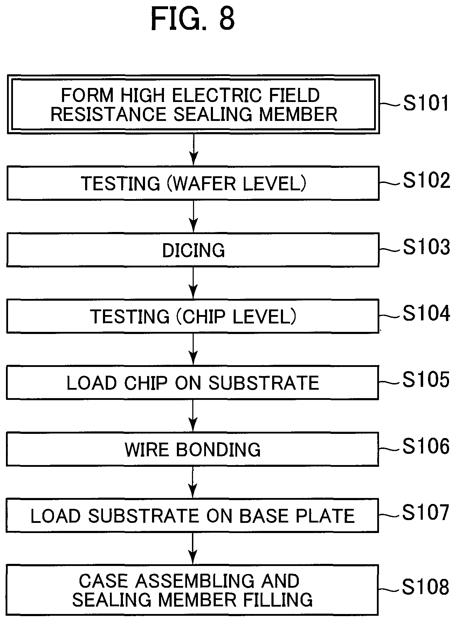

Fig. 8 is a flowchart illustrating the flow of the manufacturing process of the semiconductor device SA1 in the present first embodiment. In Fig. 8, a semiconductor wafer which is configured by the semiconductor material (SiC) which is larger than silicon in band gap and has the element formation face is prepared. The semiconductor wafer has a plurality of chip regions, each of the chip regions which are present on the semiconductor wafer has the semiconductor element formation part and the peripheral edge part which surrounds the semiconductor element formation part, the diode which is the SiC device is formed on the semiconductor element formation part and the termination part is formed on the peripheral edge part.

Next, the high electric field resistance sealing member is formed to cover the termination part formed on the peripheral edge part of each chip region in a state of the semiconductor wafer (S101). Thereafter, testing of the SiC device formed in each chip region is performed in the state of the semiconductor wafer (S102). Then, the plurality of semiconductor chips are acquired by dicing the plurality of chip regions present on the semiconductor wafer (S103). Then, testing of the SiC devices formed on the semiconductor chips is performed in a state of the segmented semiconductor chips (S104). Next, the semiconductor chips are loaded on the substrate (the insulated substrate) (S105) and thereafter the semiconductor chips are electrically connected with the wires (wire bonding) (S106) . Then, the substrate with the semiconductor chips being loaded is disposed on a base plate (S107) and thereafter case assembling and the case is filled with the silicone gel which is the sealing member (S108). It is possible to manufacture the semiconductor device in the present first embodiment in this way.

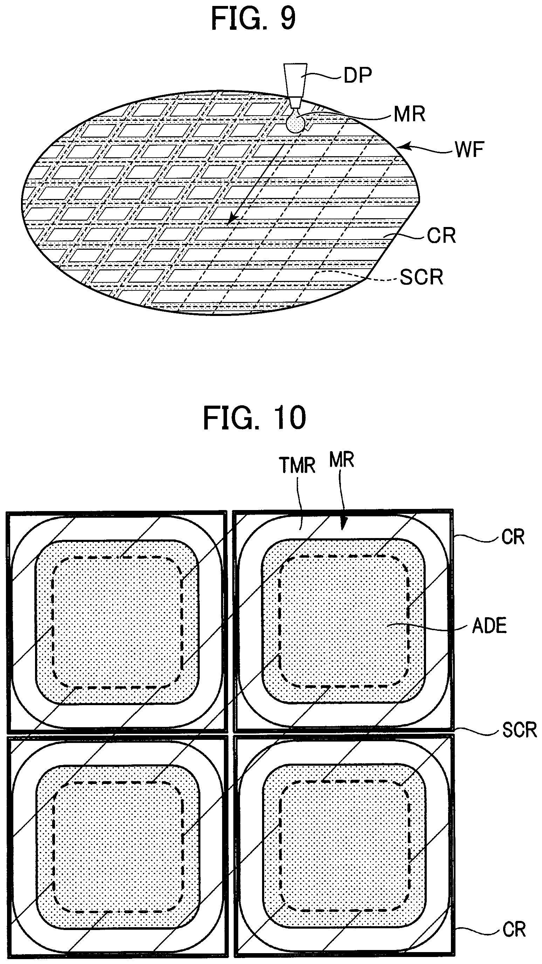

In the following, the detailed manufacturing process will be described with reference to the drawings. First, as illustrated in Fig. 9, the pasted high electric field resistance sealing member MR is applied along a scribe line SCR which partitions chip regions CR in a state of a semiconductor wafer WF. Specifically, as illustrated in Fig. 9, the high electric field resistance sealing member MR is applied onto the semiconductor wafer WF by dropping the pasted high electric field resistance sealing member MR from the dispenser DP along the scribe line SCR which is present in the form of a grid. At this time, a resin which contains polyamide-imide as a principal component was used as the high electric field resistance sealing member MR. Characteristics were such that a viscosity of the high electric field resistance sealing member MR is 100 Pa·s and the dielectric breakdown electric filed intensity of the high electric filed resistance sealing member MR was 210 kV/mm which was at least ten times the dielectric breakdown electric field intensity of the silicone gel.

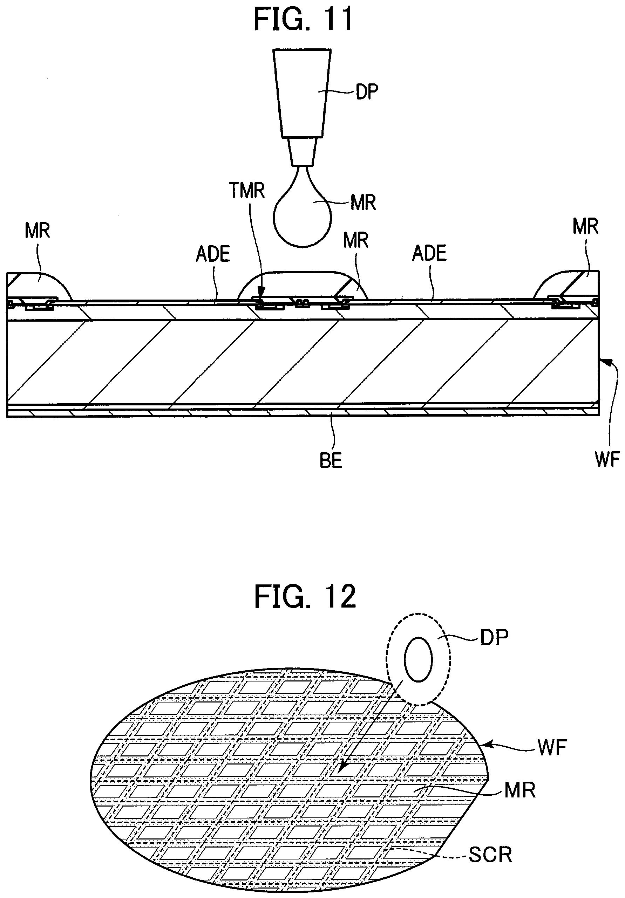

Fig. 10 is a diagram illustrating part of the semiconductor wafer in an enlarged state and the four mutually adjacent chip regions CR are illustrated. In Fig. 12, the excessive high electric field intensity sealing member MR spreads out at a crossing place of a longitudinal direction with a lateral direction by performing application of the high electric field sealing member MR in the form of the grid along the scribe line SCR. Consequently, it is possible to effectively cover a corner part (a corner part) of the termination part TMR with the high electric field resistance sealing member MR.

Fig. 11 is a sectional diagram illustrating a situation where the high electric field resistance sealing member MR is dropped from the dispenser DP to cover the termination part TMR formed on the semiconductor wafer WF. As illustrated in Fig. 11, it is found that the pasted high electric field resistance sealing member MR which is dropped from the dispenser DP is formed to cover the termination part TMR and to cover the vicinity of the end part of the anode electrode which is disposed adjacent to the termination part TMR.

Then, after application of the high electric field resistance sealing member MR, heat treatment for curing the pasted high electric field resistance sealing member MR is performed. First, the heat treatment is continuously performed under conditions of a condition 1 (100°C, twenty minutes) and a condition 2 (200°C, one hour) and thereafter additional high-temperature heat treatment is performed under a condition of a condition 3 (an inert atmosphere, 300°C, one hour). It is possible to suppress occurrence of degassing from the high electric field resistance sealing member MR in high-temperature heat treatment (355°C in maximum) performed in a chip loading process which will be described later by this additional high-temperature heat treatment. It is possible to evaluate a relation between the heat treatment and the degassing by, for example, a TDS device (a temperature-programmed desorption gas analysis device). In the manufacturing process of the semiconductor device in the present first embodiment, occurrence of degassing from the high electric field resistance sealing member MR is suppressed by imposing heat treatment at 200°C or higher which has not been performed so far on the high electric field resistance sealing member MR. Incidentally, a highest temperature for the heat treatment imposed on the high electric field resistance sealing member MR may be not more than a highest temperature in the chip loading process or less than a temperature at which pyrolysis of the high electric field resistance sealing member MR is started and is specifically not more than 400°C.

Next, the high electric field resistance sealing member MR is cured by the heat treatment and thereafter an electric characteristic inspection in a state of the semiconductor wafer WF is performed. Here, according to the present first embodiment, since the termination part TMR which is large in electric field intensity is covered with the high electric field resistance sealing member MR, discharge in the atmosphere is suppressed and consequently it is possible to perform a high-voltage application test with ease.

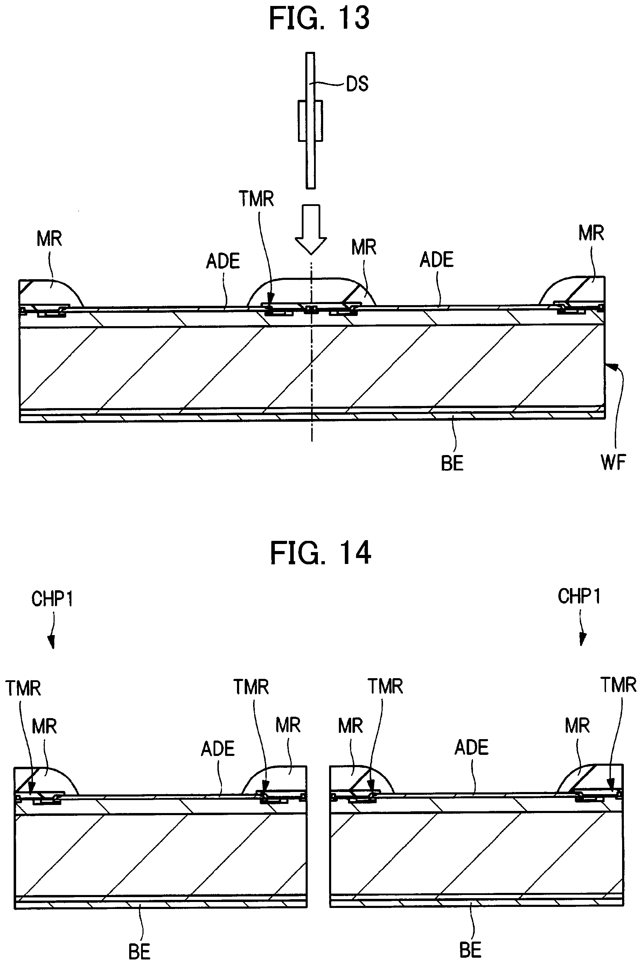

Then, as illustrated in Fig. 12, the semiconductor wafer WF is cut along the scribe line SCR of the semiconductor wafer WF that curing of the high electric field resistance sealing member MR is terminated by a dicing blade DS (dicing). FIG. 13 is a sectional diagram illustrating a situation of dicing the semiconductor wafer WF. As illustrated in Fig. 13, the dicing is performed along a dotted line passing through the high electric field resistance sealing member MR and the termination part TMR. Thereby, as illustrated in Fig. 14, the high electric field resistance sealing member MR and the termination part TMR are cut and the semiconductor wafer WF is segmented to the plurality of semiconductor chips CHP1.

Then, the electrical characteristic inspection is performed in the state of the semiconductor chips CHP1 and the semiconductor chip CHP1 which is a conforming article is sorted out. Thereafter, the semiconductor chip CHP1 is loaded on the substrate (the insulated substrate) (the chip loading process). At this time, since a high-melting-point soldering material is used for junction of the semiconductor chip CHP1 with the substrate, this chip loading process includes heat treatment performed at 355°C in maximum in a reducing atmosphere. Then, a wire bonding process of connecting a wire to the electrode (the anode electrode) of the semiconductor chip CHP1 which is joined to the substrate is performed. Next, a process of joining the substrate on which the semiconductor chips CHP1 are loaded to a base plate which serves as a bottom face of a semiconductor module which is connected to a heat sink is performed and thereafter a case assembling process and a silicone gel encapsulating process are performed. It is possible to manufacture the semiconductor device in the present first embodiment in the above-described manner.

### <Characteristics of First Embodiment>

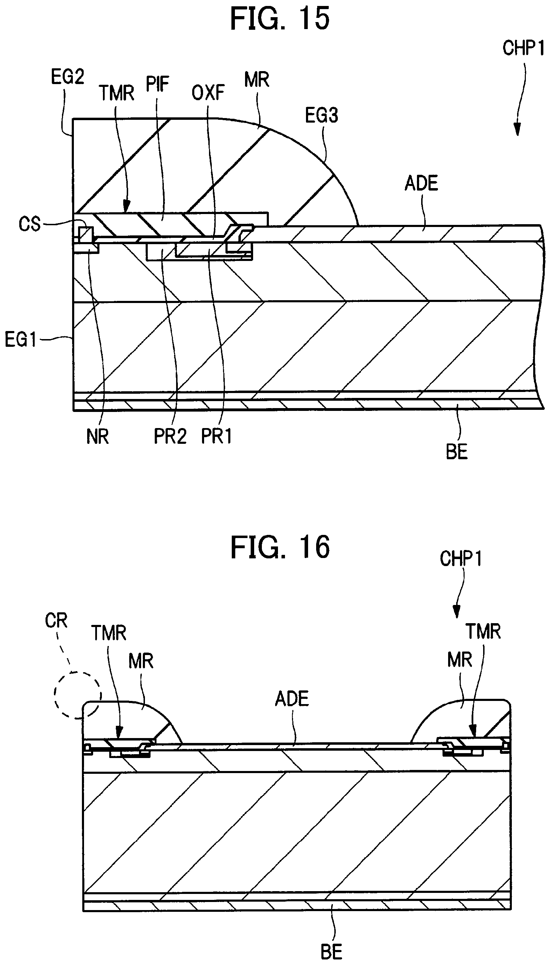

Fig. 15 is a sectional diagram illustrating the vicinity of the end part of the semiconductor chip CHP1 in the present first embodiment in an enlarged state. As illustrated in Fig. 15, in the semiconductor chip CHP1 in the first embodiment, the back-face electrode BE which functions as the cathode electrode of the diode is formed on the back face of the semiconductor chip CHP1. On the other hand, the anode electrode ADE of the diode and the termination part TMR which is formed in a region on the outer side of the anode electrode ADE are formed on the front face of the semiconductor chip CHP1. This termination part TMR has a p-type semiconductor region PR1 which is formed in the semiconductor chip CHP1 and a p-type semiconductor region PR2 which enfolds the p-type semiconductor region PR1 and is lower in impurity concentration than the p-type semiconductor region PR1. In addition, the termination part TMR has an n-type semiconductor region NR which is formed separately from the p-type semiconductor region PR2 toward the end-face side of the semiconductor chip CHP1 and a channel stop layer CS which is formed on the n-type semiconductor region NR. Further, the termination part TMR has a silicon oxide film OXF which extends from above the p-type semiconductor region PR1 and the p-type semiconductor region PR2 to reach the channel stop layer CS and a polyimide resin film PIF which covers the silicon oxide film OXF and the channel stop layer CS which projects from the silicon oxide film OXF. The polyimide resin film PIF functions as a protection film and has a film thickness of, for example, 4 µm to 9 µm.

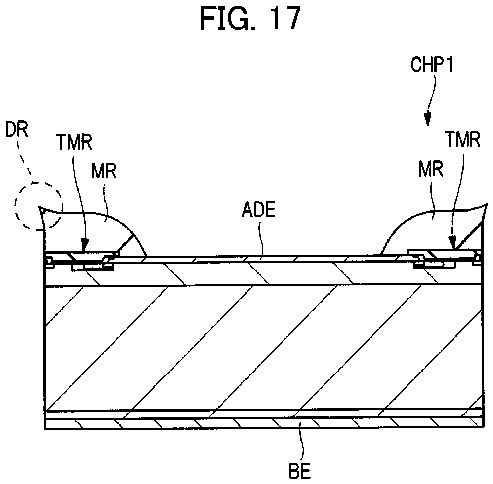

According to the termination part TMR configured in his way, since the p-type semiconductor region PR1 which is high in impurity concentration is enfolded with the p-type semiconductor region PR2 which is low in impurity concentration, it is possible to relax the electric field on the termination part TMR. Then, as illustrated in Fig. 15, the high electric field resistance sealing member MR is formed to cover the termination part TMR. Although not illustrated in Fig. 15, for example, as illustrated in Fig. 17, the silicone gel GL is formed to cover the semiconductor chip CHP1 with the high electric field resistance sealing member MR formed. The electric field from the semiconductor chip CHP1 is applied to this silicone gel GL. However, it is necessary that a film thickness of the high electric field resistance sealing member MR which is formed on the termination part TMR be, for example, at least not less than 50 µm and be desirably not less than 80 µm in order to make the electric field intensity of the electric field applied to the silicone gel GL not exceed the dielectric breakdown electric field intensity (14 kV/mm) of the silicone gel GL. On the other hand, it is necessary that the film thickness of the high electric field resistance sealing member MR be not more than 500 µm because when it is too thick, a stress is increased and an issue of cracks and so forth becomes apparent.

Incidentally, as the semiconductor chip CHP1 in the present first embodiment, a high withstand voltage product of, for example, 3.3 kV in withstand voltage is targeted. However, the semiconductor chip CHP1 in the present first embodiment is also applicable to medium withstand voltage products of 1.7 kV and 1.2 kV. In this case, although it depends on the design of the termination part TMR, it is possible to make a lower limit value of the film thickness of the high electric field resistance sealing member MR small and, for example, it is possible to set the film thickness of the high electric field resistance sealing member MR to 20 µm or more.

In addition, a relative dielectric constant of the polyimide film PIF is about 2.9, a relative dielectric constant of the polyether-amide resin which is a principal component which configures the high electric field resistance sealing member MR is about 3.2 and both are smaller than a relative dielectric constant (3.8 to 4.1) of the underlying silicon oxide film OXF. On the other hand, a relative dielectric constant of the silicone gel GL is about 2.7 and the relative dielectric constant of the polyimide film PIF and the relative dielectric constant of the high electric field resistance sealing member MR are larger than the relative dielectric constant of the silicone gel GL. From this, a relation of the relative dielectric constant of the silicon oxide film OXF > the relative dielectric constant of the polyimide film PIF and the relative dielectric constant of the high electric field resistance sealing member MR > the relative dielectric constant of the silicone gel GL is established. At this time, it is possible to reduce influence caused by accumulation of electric charges due to a difference between/among the relative dielectric constants by making the difference between/among the relative dielectric constants small and thereby it is possible to improve the reliability of the semiconductor device.

Here, a first characteristic point of the present first embodiment lies in the point that, for example, as illustrated in Fig. 15, an end face EG1 of the semiconductor chip CHP1 and an outer end part EG2 of the high electric field resistance sealing member MR are configured to include parts which are flush with each other. Thereby, according to the present first embodiment, it is possible to thicken the film thickness of the high electric field resistance sealing member MR on the end face EG1 of the semiconductor chip CHP1. From this, according to the present first embodiment, it is possible to suppress dielectric breakdown in the vicinity of the end face EG1 of the semiconductor chip CHP1 which is high in electric field intensity.

For example, as illustrated in the region AR in Fig. 6, since in the related art, the outer end part of the high electric field resistance sealing member MR is formed to trail the hem, it follows that it is configured in such a manner that the end face of the semiconductor chip CHP and the outer end part of the high electric field resistance sealing member MR do not include the parts which are flush with each other. Consequently, in the related art illustrated in Fig. 6, it becomes difficult to form the high electric field resistance sealing member MR on the vicinity of the end face of the semiconductor chip CHP which is high in electric field intensity. This means that the silicone gel GL is brought into direct contact with the vicinity of the end face of the semiconductor chip CHP which is high in electric field intensity. That is, in the related art, since the silicone gel GL which is more liable to undergo dielectric breakdown than the high electric field resistance sealing member MR is brought into direct contact with the vicinity of the end face of the semiconductor chip CHP which is high in electric field intensity, the silicone gel GL is liable to undergo dielectric breakdown in the vicinity of the end face of the semiconductor chip CHP. In other words, in the related art, since it becomes impossible to promote relaxation of the electric field intensity by the high electric field resistance sealing member MR in the vicinity of the end face of the semiconductor chip CHP which is high in electric field intensity, the intensity of the electric field imposed onto the silicone gel GL in the vicinity of the end face of the semiconductor chip CHP exceeds the dielectric breakdown electric field intensity of the silicone gel GL and therefore the fear that the dielectric breakdown of the silicone gel GL may occur is increased. Accordingly, in the related art, the dielectric breakdown of the silicone gel GL is liable to occur due to the difficulty in forming the high electric field resistance sealing member MR in the vicinity of the end face of the semiconductor chip CHP which is high in electric field intensity and thereby the reliability of the semiconductor device is lowered.

On this point, in the related art, it is conceivable to increase the width of the termination part TMR which is formed on the peripheral edge part of the semiconductor chip CHP in order to avoid an increase in electric field intensity in the vicinity of the end face of the semiconductor chip CHP. However, in this case, it follows that the size of the termination part TMR which does not function as the element formation part becomes large. This means that the size of the semiconductor chip CHP is increased and thereby an increase in manufacturing cost of the semiconductor device is induced. That is, in the semiconductor chip CHP with the SiC device formed, it is thought that a design that the electric field intensity in the semiconductor chip CHP is enhanced becomes possible owing to the high dielectric breakdown electric field intensity of SiC. However, in the related art, it is not possible to sufficiently realize the design that the electric field intensity in the semiconductor chip CHP is enhanced due to difficulty in forming the high electric field resistance sealing member MR in the vicinity of the end face of the semiconductor chip CHP which is high in electric field intensity. That is, in the related art, it becomes difficult to sufficiently realize a design which makes use of excellent material characteristics of SiC.

In contrast thereto, according to the present first embodiment, for example, as illustrated in a region BR in Fig. 7, the end face of the semiconductor chip CHP1 and the outer end part of the high electric field resistance sealing member MR are configured to include the parts which are flush with each other. Thereby, according to the present first embodiment, it is possible to thicken the film thickness of the high electric field resistance sealing member MR on the vicinity of the end face of the semiconductor chip CHP1. This means that according to the present first embodiment, it is possible to form the high electric field resistance sealing member MR which is thick in film thickness on the vicinity of the end face of the semiconductor chip CHP1. Therefore, according to the present first embodiment, since the high electric field resistance sealing member MR which is thick in film thickness is formed in the vicinity of the end face of the semiconductor chip CHP1 which is high in electric field intensity, it is possible to sufficiently relax the electric field intensity. Consequently, according to the preset first embodiment, it is possible to effectively suppress that the intensity of the electric field imposed on the silicone gel GL which is formed on the high electric field resistance sealing member MR which is thick in film thickness exceeds the dielectric breakdown electric field intensity of the silicone gel GL and thereby it is possible to effectively suppress the dielectric breakdown of the silicone gel GL. That is, according to the present first embodiment, since it is possible to interpose the high electric field resistance sealing member MR which is thick in film thickness between the semiconductor chip CHP1 and the silicone gel GL in the vicinity of the end part of the semiconductor chip CHP1, it is possible to effectively suppress the dielectric breakdown of the silicone gel GL. Therefore, according to the first characteristic point of the present first embodiment, it is possible to suppress a reduction in reliability of the semiconductor device caused by the dielectric breakdown of the silicone gel GL. In other words, according to the first characteristic point of the present first embodiment, it is possible to improve the reliability of the semiconductor device by forming the high electric field resistance sealing member MR which is thick in film thickness in the vicinity of the end face of the semiconductor chip CHP1 which is high in electric field intensity. That is, according to the first characteristic point of the present first embodiment, since it becomes possible to form the high electric field resistance sealing member MR which is thick in film thickness in the vicinity of the end face of the semiconductor chip CHP1 which is high in electric field intensity, a design that the electric field intensity in the semiconductor chip CHP1 is enhanced becomes sufficiently possible. That is, according to the present first embodiment, it is possible to sufficiently realize a design which makes use of the excellent material characteristics of SiC. Specifically, also a design that the width of the termination part TMR is made small in such a manner that a high electric field is extended up to the vicinity of the end face of the semiconductor chip CHP1 also becomes possible. This means that in the semiconductor chip CHP1 in the present first embodiment, downsizing of the semiconductor chip CHP1 owing to a reduction in occupation area of the termination part TMR which does not function as the element formation part becomes possible and thereby it is possible to promote a reduction in manufacturing cost.

From the above, it is possible to effectively suppress the dielectric breakdown of the silicone gel GL as a direct effect of the first characteristic point of the present first embodiment that it is possible to thicken the film thickness of the high electric field resistance sealing member MR on the vicinity of the end face of the semiconductor chip CHP1 and consequently it becomes possible to improve the reliability of the semiconductor device. Further, as an indirect effect of the first characteristic point of the present first embodiment, the design that the high electric field is extended up to the vicinity of the end face of the semiconductor chip CHP1 becomes possible and consequently it becomes possible to make the size of the termination part TMR which does not function as the element formation part small. From this, as the indirect effect of the first characteristic point of the preset first embodiment, it is possible to reduce the size of the semiconductor chip CHP1 and thereby it becomes possible to reduce the manufacturing cost of the semiconductor device.

Incidentally, the first characteristic point of the present first embodiment is that, for example, as illustrated in Fig. 15, the end face EG1 of the semiconductor chip CHP1 and the outer end part EG2 of the high electric field resistance sealing member MR may be configured to include the portions which are flush with each other. A portion which is not flush may be partially present on the outer end part EG2 of the high electric field resistance sealing member MR, for example, like a shape (an oblique shape) of a portion surrounded by a region CR illustrated in Fig. 16 and a shape (a projected shape) of a portion surrounded by a region DR illustrated in Fig. 17. That is, the first characteristic point of the present first embodiment is, the end face EG1 of the semiconductor chip CHP1 and the outer end part EG2 of the high electric field resistance sealing member MY may include portions which are at least partially flush with each other. Realization of this configuration leads to formation of the high electric filed resistance sealing member MR in the vicinity of the end face of the semiconductor chip CHP1 which is high in electric field intensity and it is possible to sufficiently obtain an electric filed relaxation effect by the high electric field resistance sealing member MR in the vicinity of the end face of the semiconductor chip CHP1.

Next, a second characteristic point of the present first embodiment lies in the point that, for example, as illustrated in Fig. 15, a thickness of the outer end part EG2 of the high electric field resistance sealing member MR is made thicker than thicknesses of other parts of the high electric field resistance sealing member MR. The second characteristic point of the present first embodiment is embodied as a configuration that a film thickness of an inner end part EG3 of the high electric field resistance sealing member MR is gradually thinned, for example, as illustrated in Fig. 15. In other words, it can be said that the second characteristic point of the present first embodiment is that the shape of the inner end part EG3 of the high electric field resistance sealing member MR is in the form of a gently tapered shape. Thereby, according to the present first embodiment, it is possible to make a contact area between the semiconductor chip CHP1 and the high electric field resistance sealing member MR large. This means that it is possible to improve adhesive strength between the semiconductor chip CHP1 and the high electric field resistance sealing member MR and thereby it is possible to improve the reliability of the semiconductor device. Further, according to the second characteristic point of the present first embodiment, it is possible to cover not only the termination part TMR but also a peripheral region which is adjacent to the termination part TMR with the high electric field resistance sealing member MR. This is, according to the second characteristic point of the present first embodiment, it is possible to promote relaxation of the electric field intensity by the high electric field resistance sealing member MR not only on the termination part TMR but also on the peripheral region which is adjacent to the termination part TMR and, also from this point, it is possible to promote improvement of the reliability of the semiconductor device. That is, according to the second characteristic point of the present first embodiment, it is possible to realize improvement of the adhesive strength between the high electric field resistance sealing member MR and the semiconductor chip CHP1 and expansion of an electric field relaxation region owing to expansion of the region of the semiconductor chip CHP1 which is covered with the high electric field resistance sealing member MR.

Further, for example, in Fig. 15, since the anode electrode ADE works as an equipotential surface, the electric field from the termination part TMR spreads out centering on a boundary region between the termination part TMR and the anode electrode ADE. On the other hand, as illustrated in Fig. 15, in a case where the shape of the inner end part EG3 of the high electric field resistance sealing member MR is in the form of the gently tapered shape, it follows that the high electric field resistance sealing member MR is formed to cover within a fixed distance range centering on the boundary region between the termination part TMR and the anode electrode ADE. This means that the high electric field resistance sealing member MR is formed to correspond to the electric field which spreads out centering on the boundary region between the termination part TMR and the anode electrode ADE and it becomes possible to realize the electric field relaxation effect by the high electric field resistance sealing member MR without waste. Consequently, according to the second characteristic point of the present first embodiment, it is possible to cover a region which becomes high in electric field intensity with the high electric field resistance sealing member MR. From this, according to the present first embodiment, it is possible to suppress that the intensity of the electric field imposed on the silicone gel GL exceeds the dielectric breakdown electric field intensity of the silicone gel GL not only on the outer end part EG2 of the high electric field resistance sealing member MR but also on the inner end part EG3 of the high electric field resistance sealing member MR and thereby it is possible to effectively suppress the dielectric breakdown of the silicone gel GL. According to the present first embodiment, it is possible to promote relaxation of the intensity of the electric field on the outer end part EG2 of the high electric field resistance sealing member MR by the first characteristic point and it is possible to promote relaxation of the intensity of the electric field on the inner end part EG3 of the high electric field resistance sealing member MR by the second characteristic point in this way.

In addition, according to the second characteristic point of the present first embodiment, it is also possible to obtain an advantage in a manufacturing method. That is, for example, as illustrated in Fig. 7, even in a case where a junction between the anode electrode ADE of the semiconductor chip CHP1 and the wire W approaches the boundary region between the anode electrode ADE and the termination part TMR due to positional displacement occurred in wire bonding, when the inner end part EG3 of the high electric field resistance sealing member MR has the tapered shape, interference with a heel rising part of the junction is hard to occur. Thereby, it is possible to suppress damage to the high electric field resistance sealing member MR caused by the interference.

In addition, the tapered shape of the inner end part of the high electric field resistance sealing member MR is automatically determined in accordance with an application condition under which the pasted high electric field resistance sealing member MR is applied and a patterning process for forming the inner end part of the high electric field resistance sealing member MR into the tapered shape becomes unnecessary. In particular, since alignment deviation of the semiconductor chips CHP1 loaded on the insulated substrate SUB occurs in an in-plane direction and in a height direction, accurate patterning is difficult. On this pint, in the present first embodiment, the patterning process for forming the inner end part of the high electric field resistance sealing member MR into the tapered shape is unnecessary and the advantage in this point is great. Further, since the film thickness of the high electric field resistance sealing member MR is as very thick as about 80 µm typically, the advantage that the patterning process for forming the inner end part of the high electric field resistance sealing member MR into the tapered shape is unnecessary in the present embodiment 1 becomes significant when considering that a general photolithography process which is applied to a film of up to 10 µm at most is difficult.

Incidentally, it is possible to adjust an application condition under which the pasted high electric field resistance sealing member MR is applied in a range that desirable applied film thickness and application line width are obtained by using a nozzle diameter, a discharge pressure, a gap length (a distance between a nozzle and an application object), an application speed (an in-plane moving speed of the nozzle) of the dispenser and a viscosity and a temperature of the high electric field resistance sealing member MR as an application material as parameters.

Then, a third characteristic point of the present first embodiment lies in the point that the high electric field resistance sealing member MR is not formed for each of the segmented semiconductor chips CHP1 and the high electric field resistance sealing members MR are formed in the lump in the state of the semiconductor wafer before segmented into the semiconductor chips CHP1. Specifically, as illustrated in Fig. 9, the pasted high electric field resistance sealing member MR is applied along the scribe lines SCR of the semiconductor wafer WF and thereafter, as illustrated in Fig. 12, the semiconductor wafer WF is diced along the scribe lines SCR. Thereby, it is possible to obtain the semiconductor chip CHP of the sectional shape as illustrated in Fig. 15. That is, according to the third characteristic point of the present first embodiment, it is possible to obtain the semiconductor chip CHP1 having the above-described first characteristic point. In this way, according to the present first embodiment, as illustrated in Fig. 15, the outer end part EG2 of the high electric field resistance sealing member MR is formed into an almost vertical shape and a state where the film thickness is almost maximized is retained on the outer end part EG2 of the high electric field resistance sealing member MR. This becomes important in designing the termination part TMR. That is, the termination part TMR of the small width which makes improvement of area efficiency possible becomes high in electric field intensity up to the vicinity of the end face EG1 of the semiconductor chip CHP. Therefore, for example, as in the related art illustrated in Fig. 6, when the film thickness is thinned on the outer end part of the high electric field resistance sealing member MR, it becomes impossible to sufficiently promote relaxation of the electric field intensity and the intensity of the electric field applied to the silicone gel GL which covers the high electric field resistance sealing member MR exceeds the dielectric breakdown electric field strength. Accordingly, it is necessary that the film thickness of the outer end part of the high electric field resistance sealing member MR be thick in order to realize the termination part TMR of the narrow width which makes effective utilization of the excellent physical properties of the wide band gap semiconductor material represented by SiC possible.

On this point, according to the third characteristic point of the present first embodiment, it is possible to realize the first characteristic point of the present first embodiment that it is possible to thicken the film thickness of the high electric field resistance sealing member MR on the vicinity of the end face of the semiconductor chip CHP1. From this, according to the third characteristic point of the present first embodiment, it is possible to realize the shape of the high electric field resistance sealing member MR which makes effective suppression of the dielectric breakdown of the silicone gel GL possible and consequently it is possible to improve the reliability of the semiconductor device. Further, the design that the high electric field is imposed up to the vicinity of the end part of the semiconductor chip CHP1 becomes possible by adopting the semiconductor device manufacturing method having the third characteristic point of the present first embodiment and consequently it becomes possible to make the size of the termination part TMR which does not function as the element formation part small. Therefore, according to the third characteristic point of the present first embodiment, it is possible to reduce the size of the semiconductor chip CHP1 and thereby it is possible to reduce the manufacturing cost of the semiconductor device.

Here, in regard to the shape of the high electric field resistance sealing member MR, at least part of the outer end part EG2 of the high electric field resistance sealing member MR has a vertical or nearly vertical end-part shape and thereby sealing corresponding to the structure of the semiconductor chip CHP1 that the high electric field is attained in the vicinity of the end face of the semiconductor chip CHP1 becomes possible. From this viewpoint, the shape of the high electric field resistance sealing member MR is, even in a case where part of an upper part of the outer end part is formed into an inclined shape as illustrated in Fig. 16 and even in a case where the part of the upper part of the outer end part is formed into a projected shape as illustrated in Fig. 17, it is possible to obtain the effect which is similar to that of the structure illustrated in Fig. 15.

Although the shapes illustrated in Fig. 16 and Fig. 17 are determined mainly in accordance with a relation between the strength of a thermosetting condition of the high electric field sealing member MR and a dicing condition (blade rotation speed and moving velocity), it is possible to optimize it by taking other factors such as adhesiveness between the high electric field resistance sealing member MR and the semiconductor chip CHP1 and so forth after dicing into consideration.

In addition, according to the third characteristic point of the present first embodiment, it is possible to obtain advantages described in the following. That is, in the method of applying the high electric field resistance sealing member MR onto every semiconductor chip CHP loaded on the insulated substrate SUB as in the related art illustrated in Fig. 5, there exist alignment deviations of inclination, in-plane position, rotation and so forth of the semiconductor chip CHP due to a variation in soldering material ADH used to adhere the semiconductor chips CHP to the insulated substrate SUB. From this, a highly accurate position correcting technology becomes necessary for the dispenser DP used for application of the high electric field resistance sealing member MR. For example, since an application amount of the high electric field resistance sealing member MR is sensitive to a distance between the nozzle and the object, a function of detecting a distance to the semiconductor chip CHP by a sensor and correcting the inclination of the semiconductor chip CHP is also necessary in addition to correction of the in-plane position of the nozzle by an image recognition technology. In contrast, according to the third characteristic point of the present first embodiment, all that is left is to appropriately correct the in-plane position of the nozzle by the image recognition technology by simply performing alignment on the whole semiconductor wafer only one time first and it is possible to realize a highly accurate application technology with no necessity of a height adjusting function by the sensor. In this way, according to the third characteristic point of the present first embodiment, it is possible to reduce the cost of an application device and it is possible to reduce time taken for image recognition in a process of applying the high electric field resistance sealing member MR and time taken for movement of the nozzle for every semiconductor chip, it is possible to obtain a manufacturing time reduction effect.

Further, according to the third characteristic point of the present first embodiment, since the high electric field resistance sealing member MR is not formed for every segmented semiconductor chip CHP1 and it is possible to form the high electric field resistance sealing members MR in the lump in the state of the semiconductor wafer WF before segmented into the semiconductor chips CHP1, it is possible to reduce TAT (turn-around time) of the manufacturing process. Simultaneously therewith, since the high electric field resistance sealing member MR is applied in the state of the semiconductor wafer that inclinations of the respective chip regions match one another at equal intervals, it is possible to improve also accuracy of a forming process and an inspection process of the high electric field sealing member MR. Thereby, according to the present first embodiment, it is possible to promote a reduction in disposal cost caused by defective formation of the high electric field resistance sealing member MR, simplification of the inspection process and price reduction of devices such as the dispenser and so forth.

In particular, giving some supplemental explanations to the inspection process, for example, a withstand voltage inspection of the semiconductor wafer is facilitated by forming the high electric field resistance sealing member MR in the state of the semiconductor wafer. For example, in the method of applying the high electric field resistance sealing member MR onto every semiconductor chip loaded on the insulated substrate as in the related art, the high electric field resistance sealing member MR is not formed on the semiconductor wafer at the stage of the semiconductor wafer. From this, in the related art, it follows that the withstand voltage inspection is performed on the semiconductor wafer which is in a state where the high electric field resistance sealing member MR is not formed. In this case, since aerial discharge occurs exceeding the withstand voltage in the air when a high voltage is applied to the semiconductor wafer, special attached facilities for preventing the aerial discharge by Fluorinert dropping and local atmospheric pressure rising become necessary. In contrast thereto, according to the present first embodiment, since the high electric field resistance sealing member MR is formed in the state of the semiconductor wafer, the above-described attached facilities become unnecessary and thereby it is possible to obtain an advantage that simplification and speeding-up of the inspection process become possible.

On the other hand, in the semiconductor device manufacturing method in the present first embodiment that the high electric field resistance sealing member MR is formed in the state of the semiconductor wafer, it follows that the high-temperature heat treatment which is performed in the chip loading process of loading the semiconductor chips on the insulated substrate is also imposed on the high electric field resistance sealing member MR. Accordingly, in the semiconductor device manufacturing method in the present first embodiment, it is feared that the issue of degassing from the high electric field resistance sealing member MR caused by imposition of the above-described high-temperature heat treatment on the high electric field resistance sealing member MR may become apparent. On this point, in the present first embodiment, for example, additional heat treatment at a higher temperature (about 200°C to 360°C) is performed in addition to the general heat treatment which is performed for thermosetting after the process of forming the high electric field resistance sealing member MR and thereby it is possible to perform a process of degassing from the high electric field resistance sealing member MR in advance at a stage prior to the chip loading process. Thereby, according to the present first embodiment, even in a case where there exists the process of forming the high electric field resistance sealing member MR in a process prior to the chip loading process, it is possible to suppress occurrence of degassing from the high electric field resistance sealing member MR caused by the high-temperature heat treatment in the chip loading process. Consequently, according to the present first embodiment, it is possible to improve the reliability of the semiconductor device.

### 2. Technical Idea Focusing on Plane

### <Examination of Improvement>

Although the on-resistance reduction and improvement of the withstand voltage are requested to the power semiconductor element, the on-resistance reduction and the improvement of the withstand voltage are in a trade-off relation. For example, it is effective for the on-resistance reduction to increase the area of an active region (the element formation part) to be formed on the semiconductor chip and from the viewpoint of reducing the on-resistance, it is desirable to form a planar shape of the active region into a quadrangular shape. However, when the planar shape of the active region is formed into the quadrangular shape, a corner part (a corner part) of the active region becomes higher in electric field than a side. Therefore, even when the termination part is formed to surround the active region, a reduction in withstand voltage occurs on the corner part and it is feared that the power semiconductor element may be destroyed. From this, for example, it is conducted to form the corner part of the active region into an arc shape and thereby to relax the electric field on the corner part and to secure the withstand voltage.

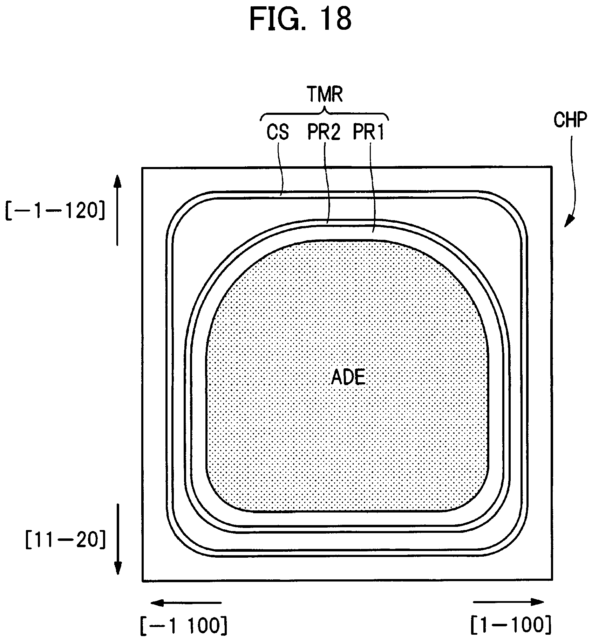

However, in a case where the corner part of the active region is formed into the arc shape, when a radius of curvature of the arc shape is increased, the area of the active region becomes small and it becomes difficult to promote sufficient on-resistance reduction. Accordingly, for example, there is related art as illustrated in Fig. 18. Fig. 18 is a plan view illustrating the semiconductor chip CHP in the related art. As illustrated in Fig. 18, the semiconductor chip CHP in the related art is, the termination part TMR configured by the p-type semiconductor region PR1, the p-type semiconductor region PR2 and the channel stop layer CS is formed to surround the anode electrode ADE formed on the active region. At this time, in the related art, it is conducted to make the radium of curvature of the corner part in a direction that the high electric field is imposed large by taking that the field effect intensity differs depending on the direction of the substrate into consideration. Specifically, as illustrated in Fig. 18, it is conducted to make the radiuses of curvature of the corner parts of the p-type semiconductor region PR1 and the p-type semiconductor region PR2 on the [-1-120] direction side from the center of the substrate larger than the radiuses of curvature of the corner parts of the p-type semiconductor region PR1 and the p-type semiconductor region PR2 on the [11-20] direction side from the center of the substrate.

Here, it is conceived to form the high electric field resistance sealing member MR to cover the termination part TMR of the semiconductor chip CHP in the related art configured as illustrated in Fig. 18. For example, in a case where the high electric field resistance sealing member MR is formed in conformity to the shape of the corner part of the large radius of curvature, since the high electric field resistance sealing member which conforms to the shape of the corner part of the large radius of curvature is also formed on the corner part of the small radius of curvature, the area of the anode electrode ADE (corresponding to the active region) is reduced. This means that a region where the wire is formed on the anode electrode ADE becomes small. Thereby, it becomes impossible to sufficiently promote the on-resistance reduction and it is concerned that interference between the high electric field resistance sealing member MR and the wire may occur and thereby a manufacturing yield of the semiconductor device may be lowered. On the other hand, in a case where the high electric field resistance sealing member MR is formed in conformity to the shape of the corner part of the small radius of curvature, since the high electric field resistance sealing member which conforms to the shape of the corner part of the small radius of curvature is also formed on the corner part of the large radius of curvature, it becomes difficult to sufficiently cover the corner part of the large radius of curvature with the high electric field resistance sealing member MR. This means that it becomes impossible to sufficiently obtain the electric field relaxation effect by the high electric field resistance sealing member MR on the corner part of the large radius of curvature. Thereby, it becomes difficult to secure the withstand voltage on the corner part of the large radius of curvature and consequently a reduction in reliability of the semiconductor device is induced.

In this way, the present inventers newly find the room for improvement which is present in the related art illustrated in Fig. 18 and make a contrivance to the room of improvement. In the following, the technical idea of the present first embodiment that this contrivance is made will be described.

### <Characteristics (Configuration) of First Embodiment>

In the semiconductor chip which contains the semiconductor material (for example, SiC) which is larger than silicon in band gap, it is premised that the semiconductor chip has the peripheral edge part, the semiconductor element formation part located on the inner side of the peripheral edge part and the high electric field resistance sealing member MR (an insulating member) which covers the peripheral edge part and surrounds the semiconductor element formation part. At this time, a fourth characteristic point of the present invention is the point that in a planar view, the shape of the inner end part of the high electric field resistance sealing member MR includes curved-line parts which are mutually different in radius of curvature. Thereby, it is possible to simultaneously attain the on-resistance reduction and the improvement of the withstand voltage.

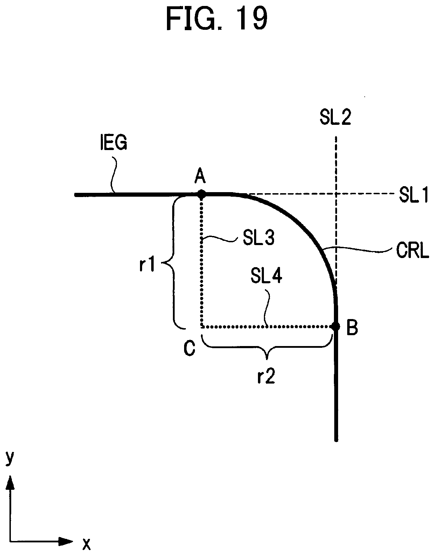

First, the definition of the "radius of curvature" in the present first embodiment will be described. Fig. 19 is a diagram illustrating the definition of the "radius of curvature" in the present invention. In Fig. 19, a thick line indicates an inner end part IEG of the high electric field resistance sealing member and the corner part is in the form of a curved-line part CRL. In Fig. 19, a straight line which extends from the inner end part IEG in an x-direction is set as a tangential line SL1 and a straight line which extends from the inner end part IEG in a y-direction is set as a tangential line SL2. Then, a point at which the tangential line SL1 is separated from the inner end part IEG is set as a point A and a point at which the tangential line SL2 is separated from the inner end part IEG is set as a point B. In addition, a line segment which is drawn from the point A vertically relative to the tangential line SL1 is set as a line segment SL3 and a line segment which is drawn from the point B vertically relative to the tangential line SL2 is set as a line segment SL4. At this time, in a case where an intersection point between the line segment SL3 and the line segment SL4 is set as a point C, a length between the point A and the point C is designated by "r1" and a length between the point B and the point C is designated by "r2". Here, the "radius of curvature" in the present first embodiment is defined as a mean value of "r1" and "r2". That is, the "radius of curvature" of the curved-line part CRL which configures the inner end part IEG of the high electric field resistance sealing member MR in the present first embodiment has the mean value of "r1" and "r2".

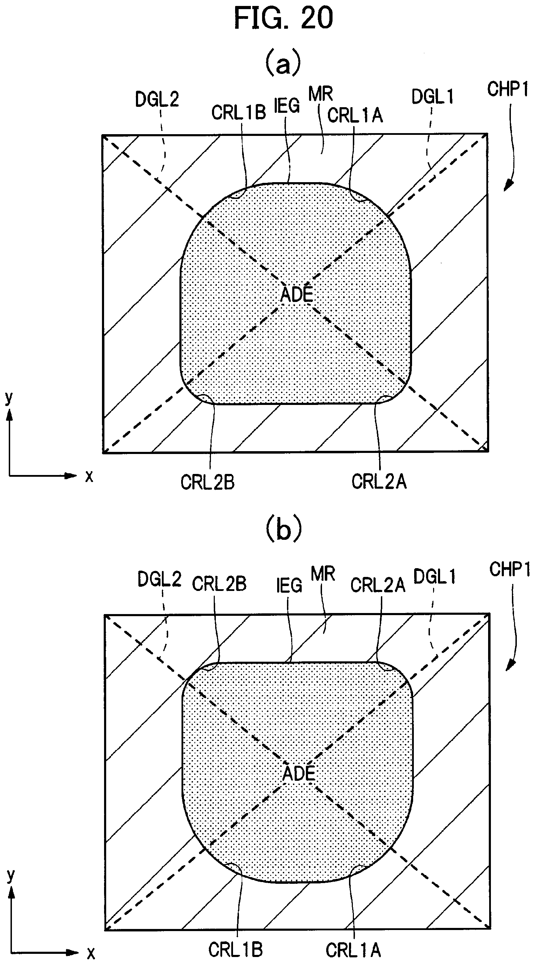

Next, Fig. 20(a) is a schematic diagram illustrating a planar configuration of the semiconductor chip CHP1 in the present invention. In Fig. 20(a), the semiconductor chip CHP1 in the present first embodiment has a rectangular shape, the peripheral edge part of the semiconductor chip CHP1 is covered with the high electric field resistance sealing member MR and the anode electrode ADE which is formed on the central part of the semiconductor chip CHP1 is exposed from the high electric field resistance sealing member MR. At this time, the fourth characteristic point of the present first embodiment lies in the point that in the planar view, the shape of the inner end part IEG of the high electric field resistance sealing member MR includes curved-line parts which are mutually different in radius of curvature. Specifically, as illustrated in Fig. 20(a), the radiuses of curvature of curved-line parts (CRL1A, CRL1B) formed on two corner parts in four corner parts are made larger than the radiuses of curvature of curved-line parts (CRL2A, CRL2B) formed on other two corner parts. That is, in the planar view, the shape of the inner end part IEG of the high electric field resistance sealing member MR includes one pair of the curved-line parts (CRL1A, CRL1B) having a first radius of curvature and one pair of the curved-line parts (CRL2A, CRL2B) having a second radius of curvature. Describing in more detail, for example, in Fig. 20(a), one pair of diagonal lines of the rectangular semiconductor chip CHP1 are set as a diagonal line DGL1 and a diagonal line DGL2. At this time, one curved-line part CRL1A in one pair of the curved-line parts (CRL1A, CRL1B) intersects with the diagonal line DGL1 and one curved-line part CRL2B in one pair of the curved-line parts (CRL2A, CRL2B) intersects with the diagonal line DGL1. On the other hand, the other curved-line part CRL1B in one pair of the curved-line parts (CRL1A, CRL1B) intersects with the diagonal line DGL2 and the other curved-line part CRL2A in one pair of the curved-line parts (CRL2A, CRL2B) intersects with the diagonal line DGL2.

According to the so configured semiconductor chip CHP1 in the present first embodiment, it is possible to cover the planar termination part TMR illustrated in Fig. 18 with, for example, the planar high electric field resistance sealing member MR illustrated in Fig. 20(a) in just proportions. That is, according to the present invention, formation of the high electric field resistance sealing member MR of the shape that the inner end part IEG includes the curved-line parts of the different radiuses of curvature becomes possible on the same semiconductor chip CHP1. Thereby, according to the present invention, since it is possible to cover a region which is necessary to be covered with the high electric field resistance sealing member MR surely with the high electric field resistance sealing member MR by covering the planar termination part TMR illustrated in Fig. 18 in just proportions, it is possible to promote improvement of the withstand voltage. At the same time, according to the present first embodiment, it is possible to increase the area of the anode electrode ADE which is exposed from the high electric field resistance sealing member MR by covering the planar termination part TMR illustrated in Fig. 18 in just proportions and consequently it is possible to promote the on-resistance reduction caused by an increase in area of the active region.

That is, according to the fourth characteristic point of the present first embodiment, since it is possible to conform the shape of the inner end part IEG of the high electric field resistance sealing member MR to the shape which covers the planar termination part TMR illustrated in Fig. 18 in just proportions, it is possible to simultaneously attain the on-resistance reduction and the improvement of the withstand voltage. In this way, according to the fourth characteristic point of the present first embodiment, it becomes possible to maximize the advantage of the planar termination part TMR having the parts which are mutually different in radius of curvature as illustrated in Fig. 18 and it is possible to realize performance improvement and reliability improvement of the semiconductor device.

Incidentally, the technical idea of the present invention is not limited to the planar configuration illustrated in Fig. 20(a) and it is also possible to realize, for example, a planar configuration illustrated in Fig. 20(b). In Fig. 20(b), one curved-line part CRL1B in one pair of the curved-line parts (CRL1A, CRL1B) intersects with the diagonal line DGL1 and one curved-line part CRL2A in one pair of the curved-line parts (CRL2A, CRL2B) intersects with the diagonal line DGL1. On the other hand, the other curved-line part CRL1A in one pair of the curved-line parts (CRL1A, CRL1B) intersects with the diagonal line DGL2 and the other curved-line part CRL2B in one pair of the curved-line parts (CRL2A, CRL2B) intersects with the diagonal line DGL2.

### <Characteristics (Manufacturing Method) of First Embodiment>

Then, the semiconductor device manufacturing method which includes the forming process of the high electric field resistance sealing member MR having the fourth characteristic point of the above-described present first embodiment will be described with reference to the drawings.

The semiconductor device manufacturing method in the present first embodiment has a fifth characteristic point which will be described in the following, with the above-described third characteristic point that the high electric field resistance sealing member MR is not formed for each of the segmented semiconductor chips CHP1 and the high electric field resistance sealing members MR are formed in the lump in the state of the semiconductor wafer before segmented into the semiconductor chips CHP1 being set forth as a premise.

First, in the forming process of the high electric field resistance sealing member MR in the present first embodiment, for example, the pasted high electric field resistance sealing member MR is applied in the form of juxtaposed lines along the x-direction (a first direction) of the semiconductor wafer WF and the pasted high electric field resistance sealing member MR is applied in the form of juxtaposed lines in the y-direction (a second direction) which is orthogonal to the x-direction while the high electric field resistance sealing member MR which is applied in the x-direction is in the pasted state before dried. Thereafter, the pasted high electric field resistance sealing member MR is cured by performing high-temperature heat treatment on the semiconductor wafer WF. Here, the fifth characteristic point lies in the point that in the forming process of the high electric field resistance sealing members MR in the present first embodiment, the pasted high electric field resistance sealing member MR is applied in the form of the juxtaposed lines in the y-direction (the second direction) which is orthogonal to the x-direction while the high electric field resistance sealing member MR applied in the x-direction is in the pasted state before dried. Thereby, the pasted high electric field resistance sealing member MR applied in the x-direction is dragged when the pasted high electric field resistance sealing member MR is applied in the y-direction on a part where the pasted high electric field resistance sealing member MR applied in the x-direction intersects with the pasted high electric field resistance sealing member MR applied in the y-direction. Consequently, the shape of the inner end part of the high electric field resistance sealing member MR is changed on a corner part of the intersection part and an increase in radius of curvature occurs.

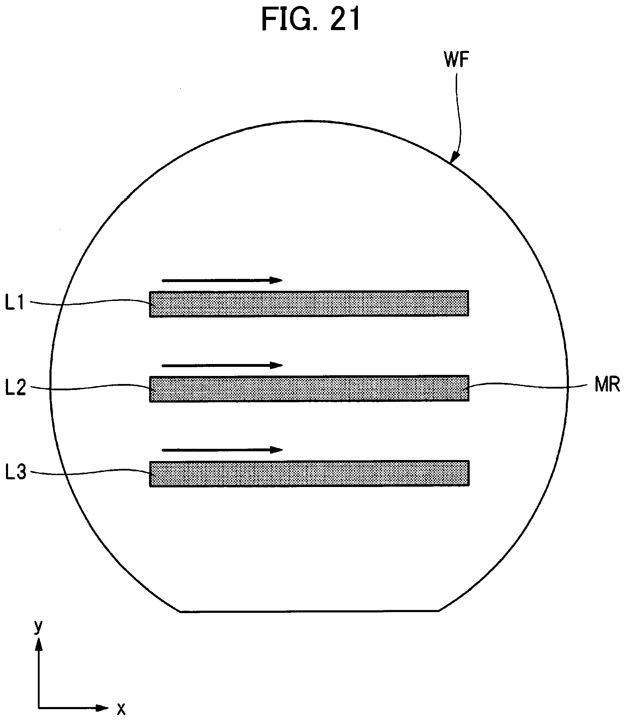

Specifically, as illustrated in Fig. 21, it is possible to realize application of the pasted high electric field resistance sealing member MR in the x-direction, for example, by ordinarily applying it in a left-to-right (or right-to-left) direction (this is called same-direction application) when viewing the semiconductor wafer from above. In addition, it is also possible to realize application of the pasted high electric field resistance sealing member MR in the x-direction by reversing an application direction line by line (this is called alternate application) in such a manner that a first line is applied from left to right, and a second line is applied from right to left and a third line is applied from left to right. For example, in Fig. 21, three lines L1 to L3 obtained by performing application of three lines by application in the same left-to-right direction are illustrated. Incidentally, it is also possible to perform application of the pasted high electric field resistance sealing member MR onto the same semiconductor wafer WF in the x-direction by mixing the same-direction application with the alternate application. In both application methods, application in the x-direction has no influence on the shape of the inner end part of the high electric field resistance sealing member MR.

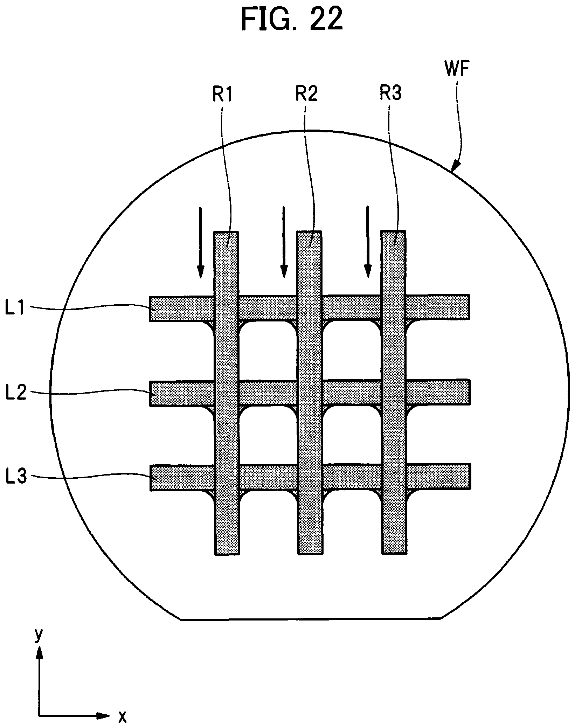

Next, as illustrated in Fig. 22, application of the pasted high electric field resistance sealing member MR in the y-direction has an influence on the shape of the inner end part the high electric field resistance sealing member MR and therefore is important. For example, in Fig. 22, three lines R1 to R3 obtained by performing application of three lines in the y-direction by the same-direction application from top to bottom are illustrated. Thereby, in intersection regions thereof with the three lines L1 to L3 formed by the application in the x-direction, the three lines L1 to L3 formed by the application in the x-direction are dragged downward and it is possible to form the high electric field resistance sealing member MR having the shape of the inner end part IEG illustrated in Fig. 20(a). On the other hand, for example, in a case where the three lines R1 to R3 are formed by performing application of the three lines in the y-direction by the same-direction application from bottom to top, in the intersection regions thereof with the three lines L1 to L3 formed by the application in the x-direction, the three lines L1 to L3 formed by the application in the x direction are dragged upward and it is possible to form the high electric field resistance sealing member MR having the shape of the inner end part IEG illustrated in Fig. 20(b).

Further, in regard to the high electric field resistance sealing member MR formed on the semiconductor wafer WF, details of a process of forming the inner end part of the high electric field resistance sealing member MR in the shape having the curved-line parts which are different in radius of curvature will be described. In the forming process of the high electric field resistance sealing member MR in the present first embodiment, the shape of the corner part of the inner end part of the high electric field resistance sealing member MR does not become right-angled and is in the form of a roundish shape which ordinarily has a certain radius of curvature and this roundish shape is caused by two factors peculiar to the present first embodiment which will be described in the following.

A first factor is attributable to spontaneous spreading of the high electric field resistance sealing member MR applied onto the semiconductor wafer WF because it is in the pasted state when applied.

The second factor is attributable to dragging of the pasted high electric field resistance sealing member MR firstly applied in the x-direction by the pasted high electric field resistance sealing member MR applied later in the y-direction which intersects with the x-direction while the high electric field resistance sealing member MR applied in the x-direction is in the pasted state in the intersection region when applying the pasted high electric field resistance sealing members MR onto the semiconductor wafer WF so as to intersect with each other vertically and horizontally. In the following, this point will be further described.

FIG. 21 is a schematic diagram illustrating a situation of applying the pasted high electric field resistance sealing member MR onto the semiconductor wafer WF in the x-direction. Here, the x-direction is a lateral direction when viewing the front face of the semiconductor wafer WF from above with an orientation flat part of the semiconductor wafer WF facing downward. For example, the pasted high electric field resistance sealing member MR is applied at intervals of 6 mm and across a width of 1.9 mm by the dispenser that a condition is adjusted in such a manner that the film thickness of the high electric field resistance sealing member MR after finally cured reaches 80 µm. Next, as illustrated in Fig. 22, following the application of the high electric field resistance sealing member MR in the x-direction, application of the pasted high electric field resistance sealing member MR in the y- direction which is orthogonal to the x direction is performed at intervals of 7 mm and across a width of 1.9 mm by using the dispenser under the condition which is the same as the condition when performing the application in the x-direction while the high electric field resistance sealing member MR applied in the x-direction maintains the pasted state. At this time, on a part where the pasted high electric field resistance sealing member MR applied in the y-direction intersects with the pasted high electric field resistance sealing member MR applied in the x- direction, the pasted high electric field resistance sealing member MR applied in the y-direction drags the pasted high electric field resistance sealing member MR applied in the x-direction. Consequently, the increase in radius of curvature of the curved-line parts formed on the two corner parts in the four corner parts which are present in the chip region occurs.

Incidentally, for example, in Fig. 22, although a boundary lines is drawn between the high electric field resistance sealing member MR applied in each of the x-direction and the y-direction and a dragged part (a spreading portion) formed by dragging the high electric field resistance sealing member applied in the y-direction the high electric field resistance sealing member MR applied in the x-direction, actually, these high electric field resistance sealing members MR are mutually mixed uniformly and the high electric field resistance sealing member MR is continuously formed. The same is true of the schematic diagrams illustrated in the following.

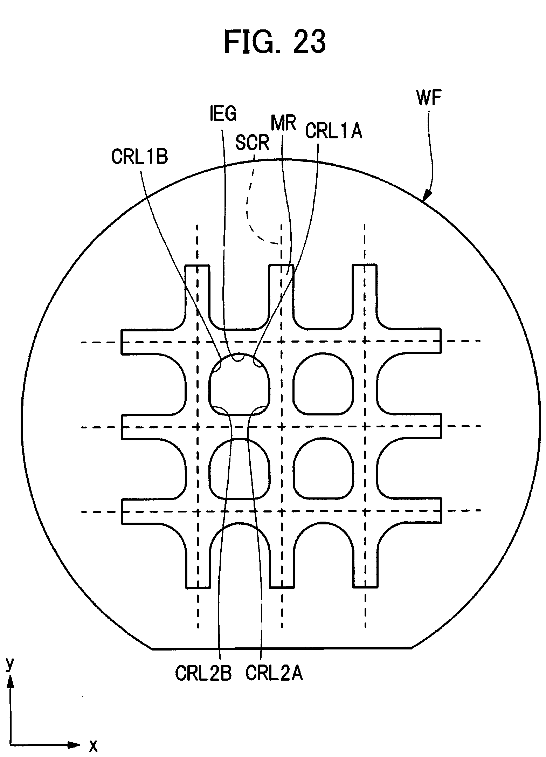

Fig. 23 is a diagram schematically illustrating the high electric field resistance sealing member MR cured in a temperature sequence of (1) 100°C, twenty minutes, (2) 200°C, one hour and (3) 300°C, one hour under a nitrogen atmosphere in a state where the semiconductor wafer WF onto which the high electric field resistance sealing member MR illustrated in Fig. 22 is applied is held horizontally. As illustrated in Fig. 23, the shape of the inner end part IEG of the high electric field resistance sealing member MR after cured includes the curved-line parts of the large radius of curvature (CRL1A, CRL1B) and the curved-line parts of the small radius of curvature (CRL2A, CRL2B). That is, the curved-line parts of the large radius of curvature (CRL1A, CRL1B) formed under influence of dragging on the intersection part and spreading of the high electric field resistance sealing member MR which uniformly occurs across the entire applied part and the curved-line parts of the small radius of curvature (CRL2A, CRL2B) that a slight increase has occurred in the radius of curvature under the influence of spreading of the high electric field resistance sealing member MR which uniformly occurs across the entire coated part are formed on the high electric field resistance sealing member MR. In this way, according to the forming process of the high electric field resistance sealing member MR in the present first embodiment, it becomes possible to form the high electric field resistance sealing member MR having the fourth characteristic of the present first embodiment that in the planar view, the shape of the inner end part of the high electric field resistance sealing member MR includes the curved-line parts which are mutually different in radius of curvature.

### <First Modified Example>

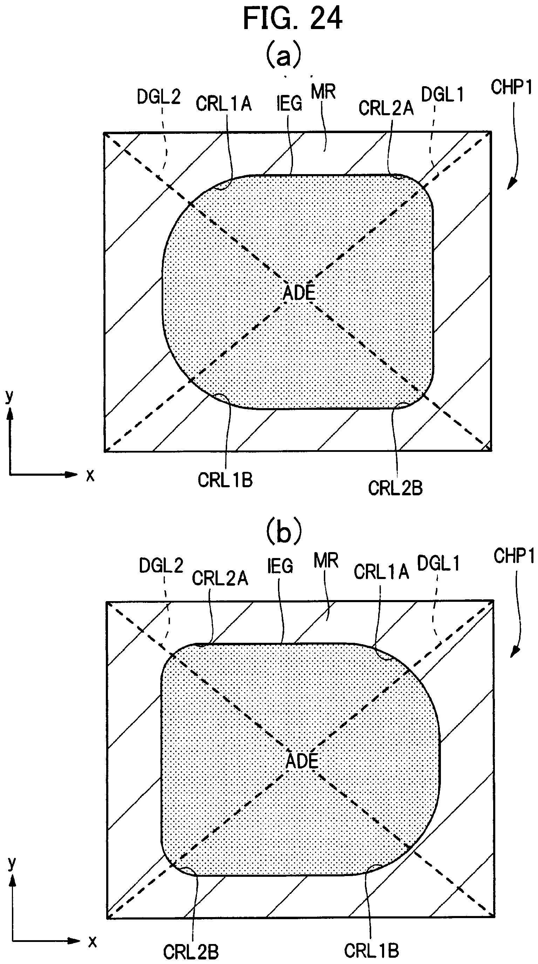

Fig. 24(a) is a diagram schematically illustrating a planar configuration of the semiconductor chip CHP1 in a first modified example of the first embodiment. As illustrated in Fig. 24(a), the semiconductor chip CHP1 in the first modified example has a rectangular shape, the peripheral edge part of the semiconductor chip CHP1 is covered with the high electric field resistance sealing member MR and the anode electrode ADE formed on the central part of the semiconductor chip CHP1 is exposed from the high electric field resistance sealing member MR. Here, for example, in Fig. 24(a), it is assumed that one pair of diagonal lines of the rectangular semiconductor chip CHP1 are the diagonal line DGL1 and the diagonal line DGL2. At this time, one curved-line part CRL1B in one pair of the curved-line lines (CRL1A, CRL1B) intersects with the diagonal line DGL1 and one curved-line part CRL2A in one pair of the curved-line parts (CRL2A, CRL2B) intersects with the diagonal line DGL1. On the other hand, the other curved-line part CRL1A in one pair of the curved-line parts (CRL1A, CRL1B) intersects with the diagonal line DGL2 and the other curved-line part CRL2B in one pair of the curved-line parts (CRL2A, CRL2B) intersects with the diagonal line DGL2. Also in the semiconductor chip CHP1 in the present first modified example, in the planar view, the shape of the inner end part IEG of the high electric field resistance sealing member MR is configured to include the curved-line parts which are mutually different in radius of curvature in this way.

Incidentally, the semiconductor chip CHP1 in the present first modified example may have a planar configuration illustrated in Fig. 24(b) that left and right are reversed to the planar configuration illustrated in Fig. 24(a), not limited to the planar configuration illustrated in Fig. 24 (a). At this time, in Fig. 24 (b), one curved-line part CRL1A in one pair of the curved-line parts (CRL1A, CRL1B) intersects with the diagonal line DGL1 and one curved-line part CRL2B in one pair of the curved-line parts (CRL2A, CRL2B) intersects with the diagonal line DGL1. On the other hand, the other curved-line part CRL1B in one pair of the curved-line parts (CRL1A, CRL1B) intersects with the diagonal line DGL2 and the other curved-line part CRL2A in one pair of the curved-line parts (CRL2A, CRL2B) intersects with the diagonal line DGL2. In this way, also in the semiconductor chip CHP1 illustrated in Fig. 24(b), in the planar view, the shape of the inner end part IEG of the high electric field resistance sealing member MR is configured to include the curved-line parts which are mutually different in radius of curvature.

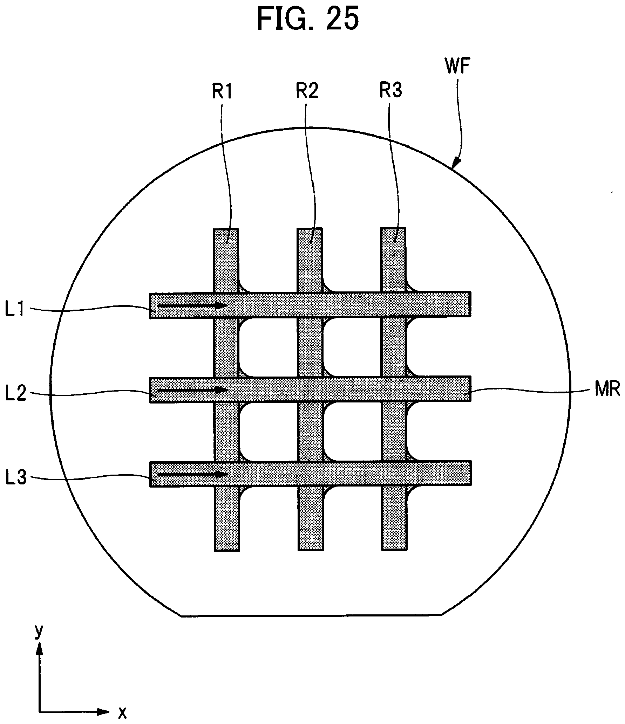

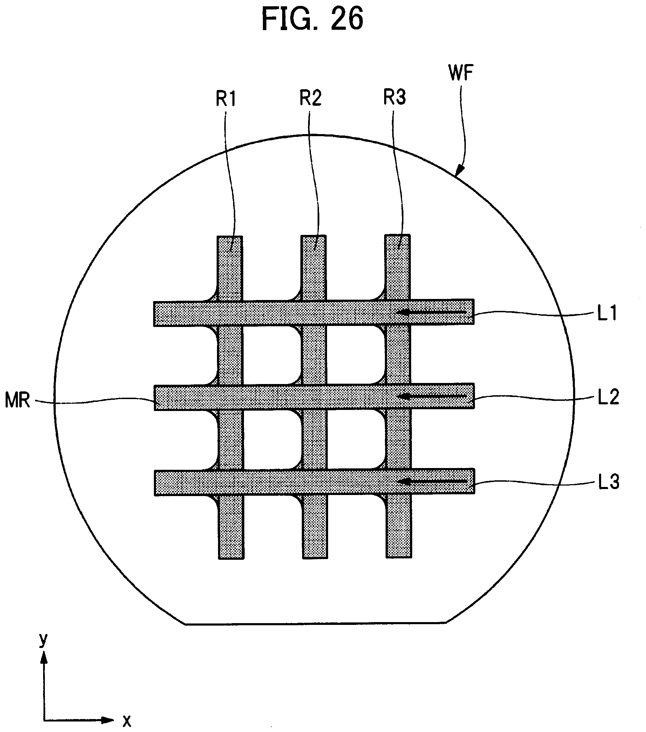

Fig. 25 is a diagram schematically illustrating a manufacturing process for realizing the shape of the inner end part IEG of the high electric field resistance sealing member MR illustrated in Fig. 24 (a) . First, as illustrated in Fig. 25, application of the pasted high electric field resistance sealing member MR in the y-direction is performed. For example, in Fig. 25, the three lines R1 to R3 are illustrated. Next, as illustrated in Fig. 25, application of the pasted high electric field resistance sealing member MR in the x-direction is performed. For example, in Fig. 25, the three lines L1 to L3 obtained by performing application of three lines in the x-direction by the same-direction application from left to right are illustrated. Thereby, in intersection regions thereof with the three lines R1 to R3 formed by application in the y- direction, the three lines R1 to R3 formed by the application in the y-direction are dragged rightwards and it is possible to form the high electric field resistance sealing member MR having the shape of the inner end part IEG illustrated in Fig. 24(a). On the other hand, as illustrated in Fig. 26, for example, in a case where the three lines L1 to L3 are formed by performing application of three lines in the x-direction by the same-direction application from right to left, in intersection regions thereof with the three lines R1 to R3 formed by the application in the y-direction, the three lines R1 to R3 which are formed by the application in the y-direction are dragged leftwards and it is possible to form the high electric field resistance sealing member MR having the shape of the inner end part IEG illustrated in Fig. 24(b).

### <Second Modified Example>

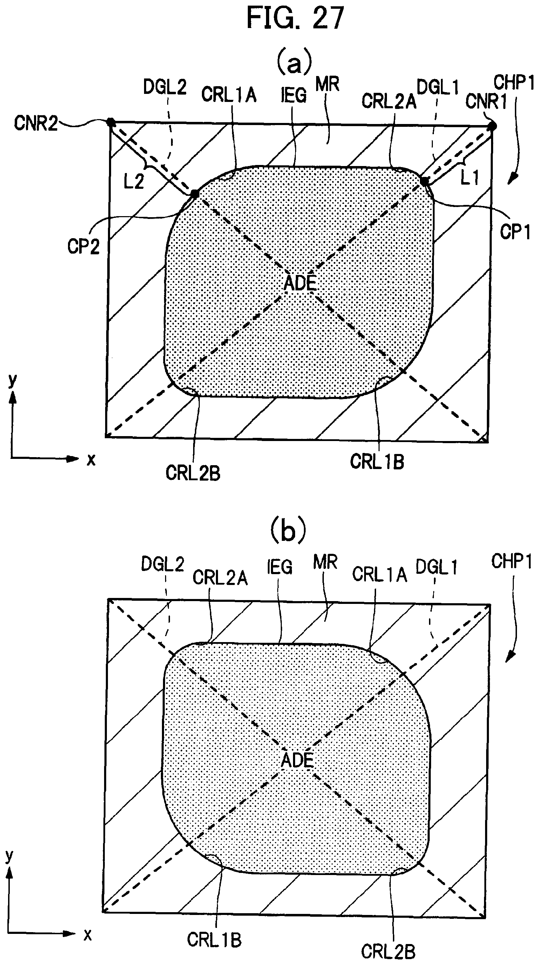

Fig. 27(a) is a diagram schematically illustrating a planar configuration of the semiconductor chip CHP1 in a second modified example of the first embodiment. Here, each of one pair of the curved-line parts (CRL2A, CRL2B) intersects with the diagonal line DGL1 and each of one pair of the curved-line parts CRL1A, CRL1B) intersects with the diagonal line DGL2. In this way, also in the semiconductor chip CHP1 in the present second modified example, in the planar view, the shape of the inner end part IEG of the high electric field resistance sealing member MR is configured to include the curved-line parts which are mutually different in radius of curvature.

Incidentally, the semiconductor chip CHP1 in the present second modified example may have a planar configuration illustrated in Fig. 27(b) that left and right are reversed to the planar configuration illustrated in Fig. 27(a), not limited to the planar configuration illustrated in Fig. 27(a). At this time, in Fig. 27(b), each of one pair of the curved-line parts (CRL1A, CRL1B) intersects with the diagonal line DGL1 and each of one pair of the curved-line parts CRL2A, CRL2B) intersects with the diagonal line DGL2. In this way, also in the semiconductor chip CHP1 illustrated in Fig. 27(b), in the planar view, the shape of the inner end part IEG of the high electric field resistance sealing member MR is configured to include the curved-line parts which are mutually different in radius of curvature.

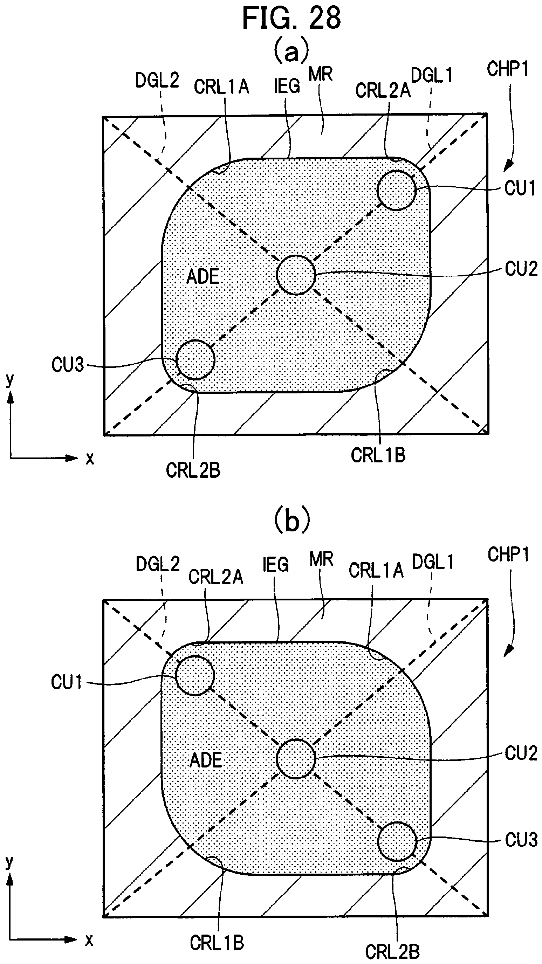

Fig. 28(a) is a schematic diagram illustrating a state where coupling parts CU1 to CU3 with the wires are formed on a front face of the anode electrode ADE formed on the element formation part in the semiconductor chip CHP1 having the planar configuration illustrated in Fig. 27(a). As illustrated in Fig. 28(a), the curved-line parts (CRL2A, CRL2B) having the small radius of curvature are formed to intersect with the diagonal line DGL1. Accordingly, the width of the anode electrode ADE along the diagonal line DGL1 is increased and consequently it is possible to dispose the plurality of coupling parts CU1 to CU3 of the semiconductor chip CHP1 with each of the plurality of wires along this diagonal line DGL1. That is, according to the present second modified example, it is possible to obtain an advantage that it becomes easy to dispose the plurality of connection parts CU1 to CU3 along the diagonal line DGL1 by forming the shape of the inner end part IEG of the high electric field resistance sealing member MR in such a manner that the radiuses of curvature of the curved-line parts (CRL2A, CRL2B) which intersect with the diagonal line DGL1 become small. In this case, it is easy to equalize values of current flowing into the plurality of wires and it is possible to improve the reliability of the semiconductor device. On the other hand, since the width of the anode electrode ADE along the diagonal line DGL2 is reduced and the area covered with the high electric field resistance sealing member MR is increased by forming the shape of the inner end part IEG of the high electric field resistance sealing member MR in such a manner that the radiuses of curvature of the curved-line parts (CRL1A, CRL1B) which intersect with the diagonal line DGL2 become large, it is possible to improve the withstand voltage of the semiconductor chip CHP1. In this way, in the present second modified example, as illustrated in Fig. 27(a), a width L1 of the high electric field resistance sealing member MR which is a distance between a corner part CNR1 which is a one-end point of the diagonal line DGL1 and a cross-point CP1 of the curved-line part CRL2A with the diagonal line DGL1 is made smaller than a width L2 of the high electric field resistance sealing member MR which is a distance between a corner part CNR2 which is a one-end point of the diagonal line DGL2 and a cross-point CP2 of the curved-line part CRL1A with the diagonal line DGL2. Thereby, the width L1 of the high electric field resistance sealing member MR along the diagonal line DGL1 becomes small and consequently it is possible to obtain an advantage that it becomes easy to dispose the plurality of connection parts CU1 to CU3 along the diagonal line DGL1 and the width L2 of the high electric field resistance sealing member MR along the diagonal line DGL2 becomes large and consequently it is possible to improve the withstand voltage.

Likewise, Fig. 28(b) is a schematic diagram illustrating a state where in the semiconductor chip CHP1 having the planar configuration illustrated in Fig. 27(b), the connection parts CU1 to CU3 with the wires are formed on the front face of the anode electrode ADE formed on the element formation part. As illustrated in Fig. 28(b), the curved-line parts of the small radius of curvature (CRL2A, CRL2B) are formed to intersect with the diagonal line DGL2. Accordingly, the width of the anode electrode ADE along the diagonal line DGL2 is increased and consequently it is possible to dispose the plurality of connection parts CU1 to CU3 of the semiconductor chip CHP1 with each of the plurality of wires. That is, according to the present second modified example, the shape of the inner end part IEG of the high electric field resistance sealing member MR is formed in such a manner that the radiuses of curvature of the curved-line parts (CRL2A, CRL2B) which intersect with diagonal line DGL2 become small and thereby it is possible to obtain an advantage that it becomes easy to dispose the plurality of coupling parts CU1 to CU3 along the diagonal line DGL2. In this case, it is easy to equalize the values of current flowing into the plurality of wires and it is possible to improve the reliability of the semiconductor device. On the other hand, since the width of the anode electrode ADE along the diagonal line DGL1 is reduced and the area covered with the high electric field resistance sealing member MR is increased by forming the shape of the inner end part IEG of the high electric field resistance sealing member MR in such a manner that the radiuses of curvature of the curved-line parts (CRL1A, CRL1B) which intersect with the diagonal line DGL1 become large, it is possible to improve the withstand voltage of the semiconductor chip CHP1.

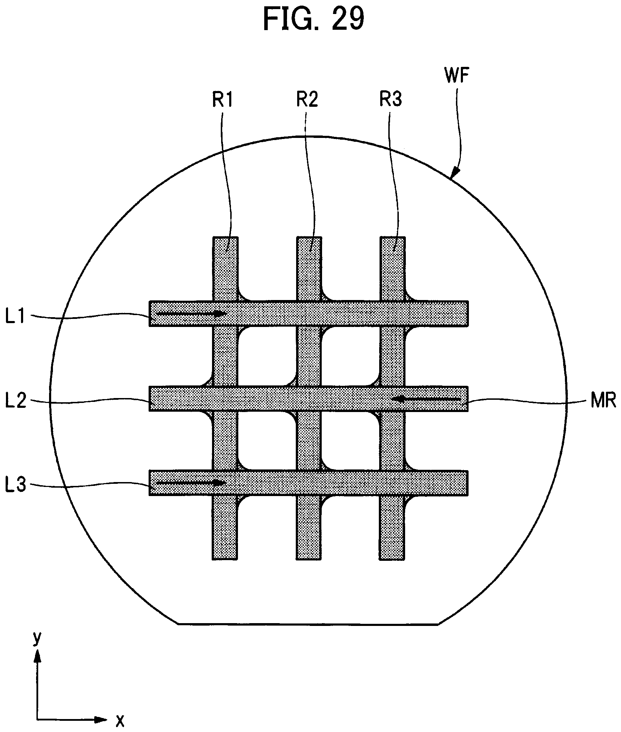

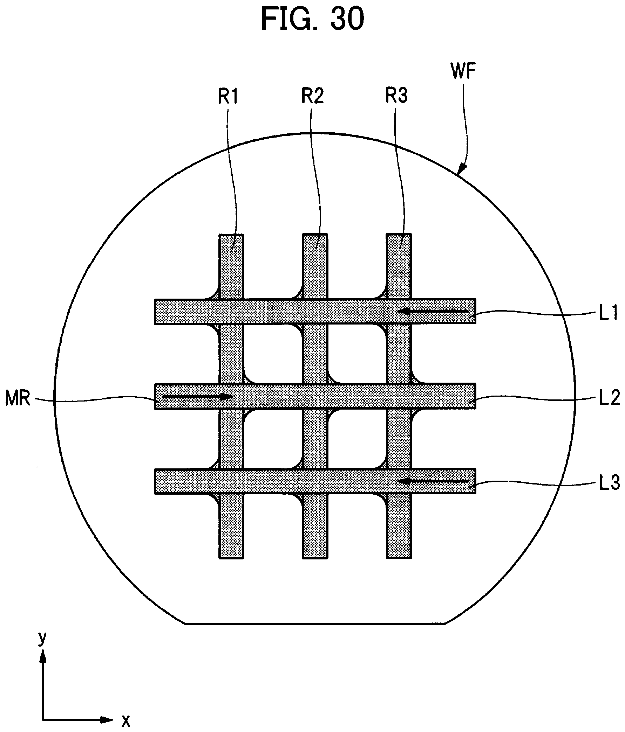

Fig. 29 is a diagram schematically illustrating a manufacturing process for realizing the shape of the inner end part IEG of the high electric field resistance sealing member MR illustrated in Fig. 27 (a) . First, as illustrated in Fig. 29, application of the pasted high electric field resistance sealing member MR in the y-direction is performed. For example, in Fig. 29, the three lines R1 to R3 are illustrated. Next, as illustrated in Fig. 29, application of the pasted high electric field resistance sealing member MR in the x-direction is performed. For example, in Fig. 29, the three lines L1 to L3 obtained by performing application of three lines in the x-direction by the alternate application are illustrated. Thereby, in the intersection regions thereof with the three lines R1 to R3 formed by the application in the y-direction, the three lines R1 to R3 formed by the application in the y-direction are dragged as illustrated in Fig. 29 and it is possible to form the high electric field resistance sealing member MR having the shape of the inner end part IEG illustrated in Fig. 27 (a). On the other hand, as illustrated in Fig. 30, for example, in a case where the three lines L1 to L3 are formed by performing the application of three lines in the x-direction reversely to the case in Fig. 29, in the intersection regions thereof with the three lines R1 to R3 formed by the application in the y-direction, the three lines R1 to R3 are dragged and it is possible to form the high electric field resistance sealing member MR having the shape of the inner end part IEG illustrated in Fig. 27(b).

### <Specific Examples of Dimensions>

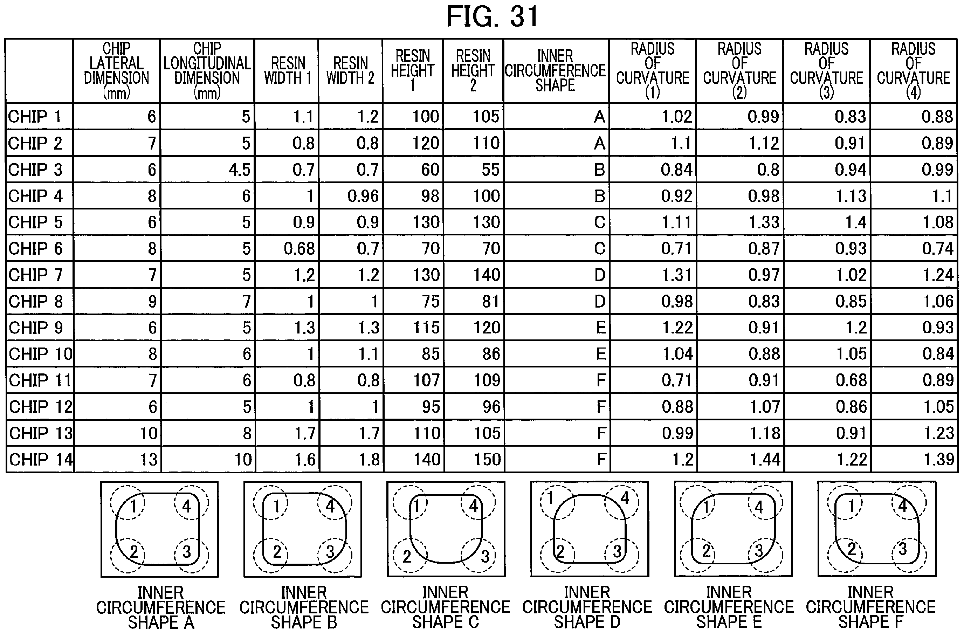

Next, specific examples of dimensions in the planar configuration of the semiconductor chip CHP1 will be described. Fig. 31 is a diagram illustrating specific examples of numerical values of respective parameters in regard to each of a plurality of chips 1 to 14 defined by the respective parameters. In Fig. 31, "Chip Lateral Dimension" indicates a lateral width of each chip and "Chip Longitudinal Dimension" indicates a longitudinal width of the chip. "Resin Width 1" indicates a dimension (a minimum part) (mm) which is one half the width of the high electric field resistance sealing member (a resin) applied in a lateral direction and "Resin Width 2" indicates a dimension (the minimum part) which is one half the width of the high electric field resistance sealing member MR applied in a longitudinal direction. "Resin Height 1" indicates a maximum thickness (µm) of the high electric field resistance sealing member MR (the resin) applied in the lateral direction and "Resin Height 2" indicates a maximum thickness (µm) of the high electric field resistance sealing member MR applied in the longitudinal direction. Each of "Inner Circumference Shapes A to F" indicates a shape illustrated in Fig. 31. Each of "Radiuses of Curvatures 1 to 4" is a radius of curvature (mm) of a curved-line part surrounded by a broken line in Fig. 31.

### <Configuration of Semiconductor Module>

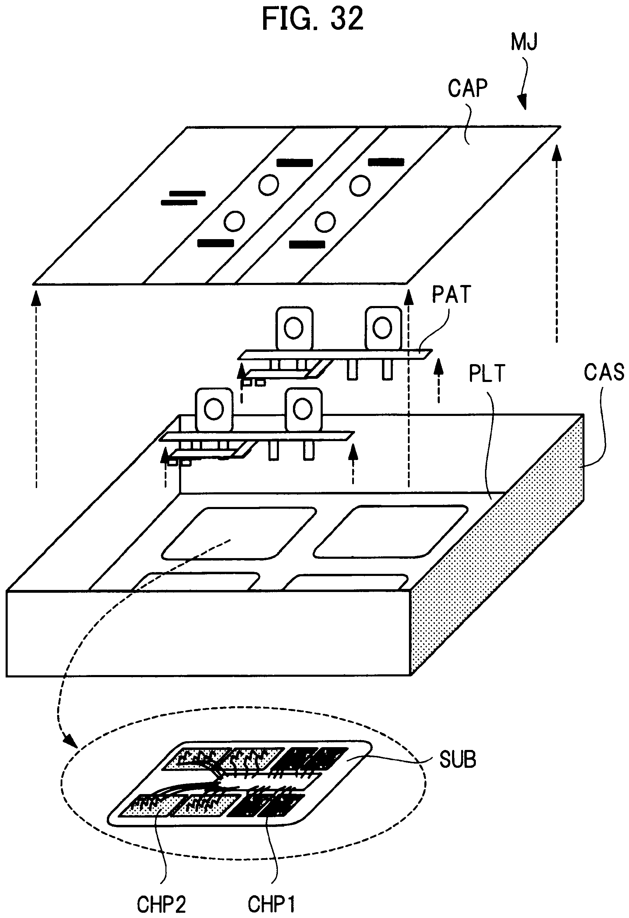

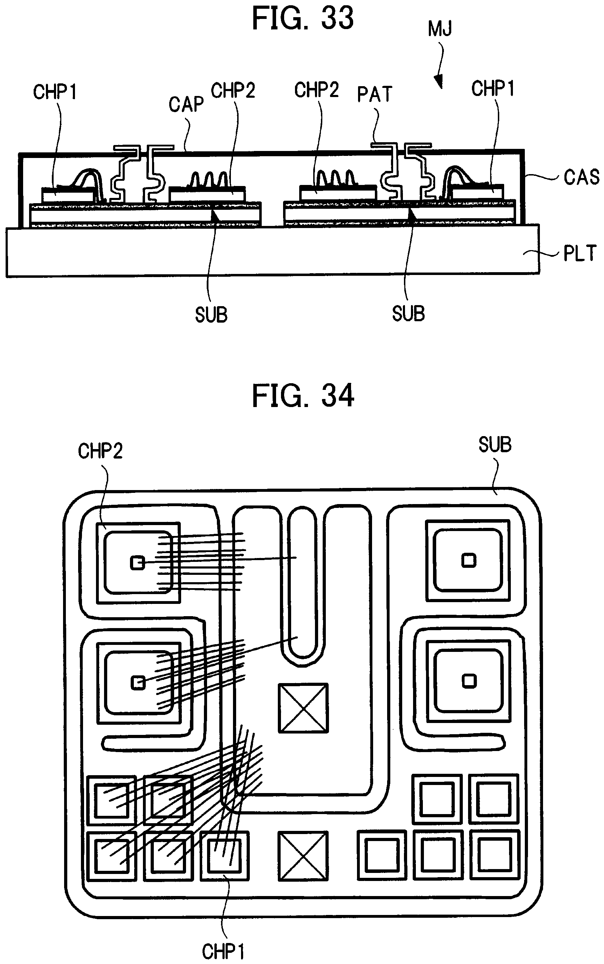

Then, a configuration of a semiconductor module in the present first embodiment will be described. Fig. 32 and Fig. 33 are schematic diagrams illustrating a configuration of a semiconductor module MJ in the present first embodiment. As illustrated in Fig. 32 and Fig. 33, for example, the plurality of semiconductor chips CHP1 in the present first embodiment with the diodes formed and a plurality of semiconductor chips CHP2 with the Si-IGBTs which function as switching elements formed are loaded on the insulated substrate SUB.

Fig. 34 is a schematic diagram illustrating a planar configuration example of the insulated substrate SUB. As illustrated in Fig. 34, for example, the ten semiconductor chips CHP1 with the diodes (SiC devices) formed and the four semiconductor chips CHP2 with the Si-IGBTs formed are loaded on the insulated substrate SUB. As illustrated in Fig. 34, a terminal is formed on a central part of the insulated substrate SUB, the terminal is electrically coupled with the plurality of semiconductor chips CHP1 via the wires and the terminal is electrically coupled with the plurality of semiconductor chips CHP2 via the wires.

Then, as illustrated in Fig. 32 and Fig. 33, the insulated substrate SUB on which the plurality of semiconductor chips CHP1 and the plurality of semiconductor chips CHP2 are loaded is disposed on a base plate PLT which configures a lower face of a case CAS. The plurality of insulated substrates SUB are disposed on this base plate PLT. The insulated substrate SUB disposed on the base plate PLT is coupled with a member (a heat radiation member, a coupling member) PAT. The member PAT is coupled with a cap CAP which is a lid of the case CAS. Further, an inner space of the case CAS is sealed with, for example, the silicone gel (the sealing member).

In this way, the semiconductor module MJ in the present first embodiment is configured. It becomes possible to realize the power conversion device represented by the inverter and the converter by combining the plurality of semiconductor modules MJ in the present first embodiment with one another.

### (Second Embodiment)

Although in the above-described first embodiment, description is made by giving the diode as an example of the SiC device, in the present second embodiment, description will be made by giving the SiC MOSFET as one example of the SiC device.

### <Examination of Improvement>

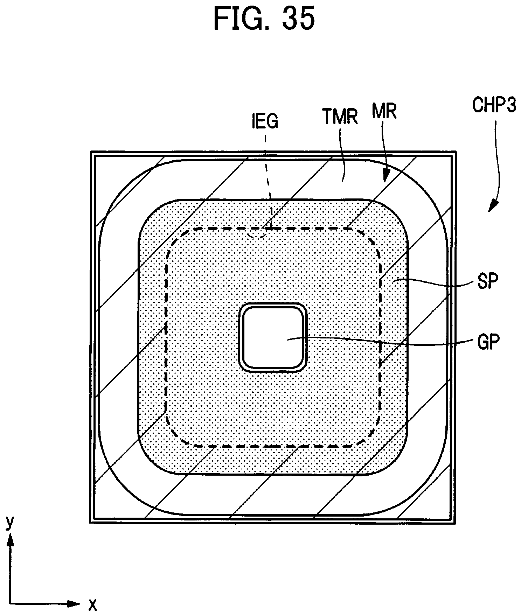

Fig. 35 is a diagram illustrating a planar configuration of a semiconductor chip CHP3 with the SiC-MOSFET formed. As illustrated in Fig. 35, the semiconductor chip CHP3 has a rectangular shape, a gate pad GP is disposed on its central part, and a source pad SP is disposed to surround this gate pad GP and the termination part TMR is disposed to surround the source pad SP. Then, the high electric field resistance sealing member MR is formed to cover part of the source pad SP from the termination part TMR. In the semiconductor chip CHP3 so configured, the wire is coupled the source pad SP and the wire is also coupled to the gate pad GP. However, since the gate pad GP is disposed on a central part of the source pad SP, the gate pad GP becomes an obstacle when coupling the source pad SP and the wire with each other.

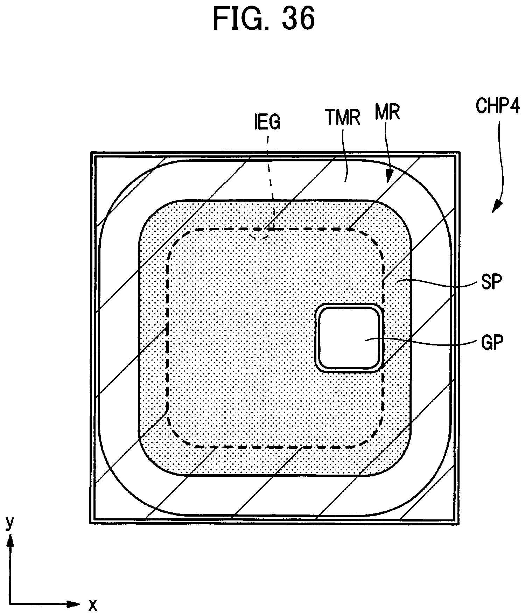

Accordingly, for example, it is examined not to dispose the gate pad GP on the central part of the source pad SP but to dispose the gate pad GP in the vicinity of an end part of the source pad SP in such a manner that it does not become the obstacle when coupling the source pad SP and the wire with each other. Fig. 36 is a diagram illustrating a semiconductor chip CHP4 of a planar configuration that the gate pad SP is disposed in the vicinity of the end part of the source pad SP. As illustrated in Fig. 36, in the semiconductor chip CHP4, the gate pad GP is disposed deviating from the central part of the source pad SP to the + x-direction side. Thereby, according to the planar configuration of the semiconductor chip CHP4, it is possible to obtain an advantage that the gate pad GP does not become the obstacle and it becomes easy to couple the source pad SP with the wire.

However, in a case of this configuration, disadvantages which will be indicated in the following occur. That is, to dispose the gate electrode GP in the vicinity of the end part of the source pad SP means that the gate pad GP draws near the high electric field resistance sealing member MR. In this case, for example, when the high electric field resistance sealing member MR is applied, a position to which the high electric field resistance sealing member MR is applied deviates, the pasted high electric field resistance sealing member MR spreads out and thereby a fear that part of the gate pad GP may be covered with the high electric field resistance sealing member MR to hinder coupling of the gate pad GP with the wire occurs.

### <Characteristics of Second Embodiment>

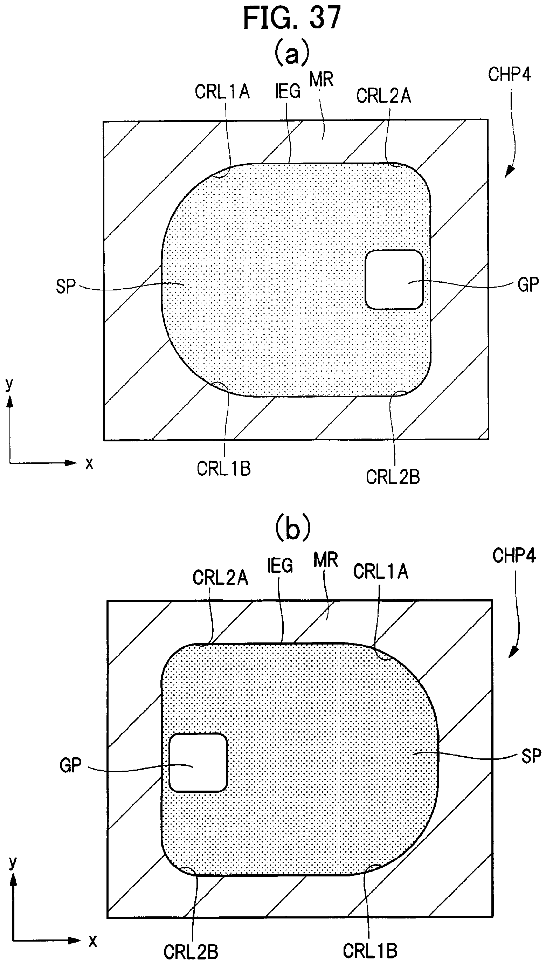

Therefore, in the present second embodiment, contrivances which will be described in the following are made. Fig. 37 (a) is a schematic diagram illustrating a planar configuration of the semiconductor chip CHP4 in the present second embodiment according to the present invention. As illustrated in Fig. 37(a), in the semiconductor chip CHP4 in the present second embodiment, the high electric field resistance sealing member MR is formed to surround the source pad SP and the inner end part IEG of this high electric field resistance sealing member MR is configured to include one pair of the curved-line parts (CRL1A, CRL1B) of the large radius of curvature and one pair of the curved-line parts (CRL2A, CRL2B) of the small radius of curvature.

Then, a characteristic point of the present second embodiment lies in the point that as illustrated in Fig. 37(a), the gate pad GP is disposed at a position closer to one pair of the curved-line parts of the small radius of curvature (CRL2A, CRL2B) than to one pair of the curved-line parts of the large radius of curvature (CRL1A, CRL1B) . Thereby, it is possible to suppress covering of part of the gate pad GP with the high electric field resistance sealing member MR irrespective of disposition of the gate pad GP in the vicinity of the end part of the source pad SP. This is because it becomes more difficult for the high electric field resistance sealing member MR to spread out on the side of one pair of the curved-line parts of the small radius of curvature (CRL2A, CRL2B) than on the side of one pair of the curved-line parts of the large radius of curvature (CRL1A, CRL1B). Consequently, according to the present second embodiment, since it is possible to suppress covering of the part of the gate pad GP with the high electric field resistance sealing member MR, it is possible to promote improvement of the manufacturing yield of the semiconductor device and improvement of the reliability of the semiconductor device.

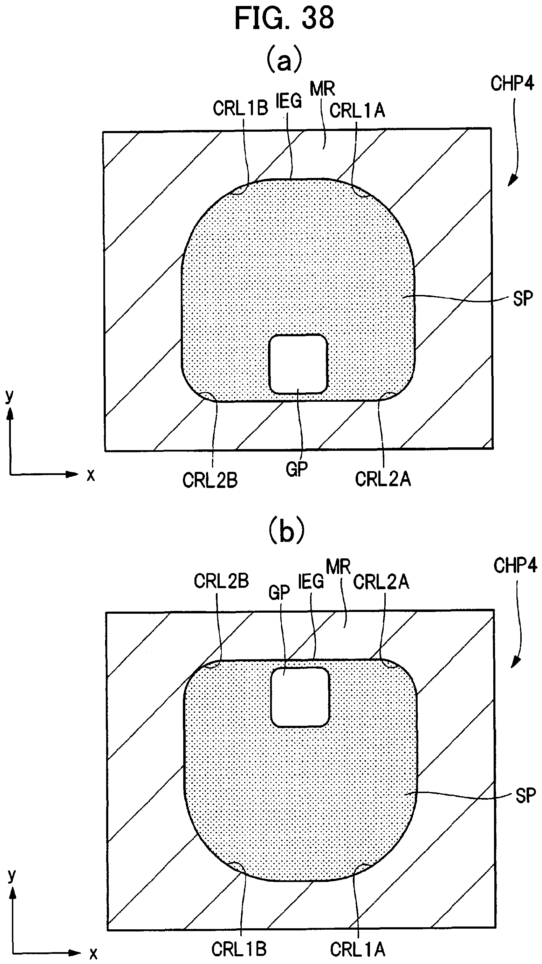

Incidentally, the semiconductor chip CHP4 in the present second embodiment may have a planar configuration illustrated in Fig. 37(b) that left and right are reversed to the planar configuration illustrated in Fig. 37(a), not limited to the planar configuration illustrated in Fig. 37(a) . At this time, in Fig. 37(b), it follows that the gate pad GP is disposed in the vicinity of a left end part of the source pad SP. Further, the semiconductor chip CHP4 in the present second embodiment may also have a planar configuration illustrated in Fig. 38(a) and a planar configuration illustrated in Fig. 38(b), not limited to the planar configurations illustrated in Fig. 37(a) and Fig. 37(b). At this time, in Fig. 38(a), it follows that the gate pad GP is disposed in the vicinity of a lower end part of the source pad SP and in Fig. 38(b), it follows that the gate pad GP is disposed in the vicinity of an upper end part of the source pad SP.

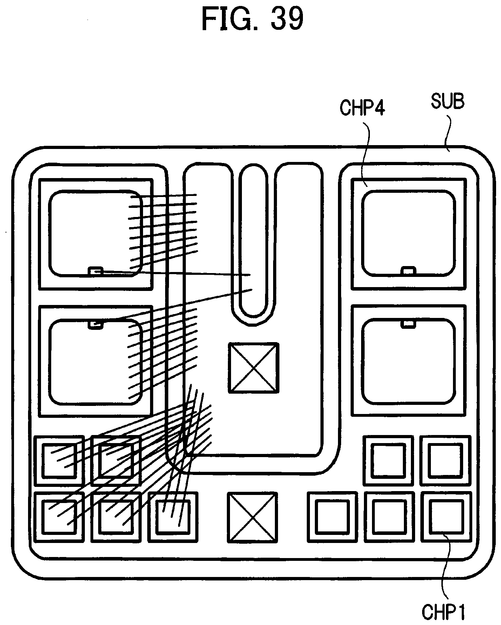

Fig. 39 is a schematic diagram illustrating a planar configuration example of the insulated substrate SUB. As illustrated in Fig. 39, for example, the ten semiconductor chips CHP1 with the diodes (the SiC devices) formed and the four semiconductor chips CHP4 in the present second embodiment with the SiC-MOSFETs formed are loaded on the insulated substrate SUB. As illustrated in Fig. 39, the terminal is formed on the central part of the insulated substrate SUB, the terminal is electrically coupled with the plurality of semiconductor chips CHP1 via the wires and the terminal is electrically coupled with the plurality of semiconductor chips CHP4 via the wires. In this case, the gate pads formed on the semiconductor chips CHP4 are electrically coupled with the terminal of the insulated substrate SUB via the wires and the source pads formed on the semiconductor chips CHP4 are electrically coupled with the terminal of the insulated substrate SUB via the wires. At this time, according to the present second embodiment, since the gate pad is disposed in the vicinity of the end part of the source pad, it is possible to electrically couple the source pad with the terminal of the insulated substrate SUB without being hindered by the gate pad.

The technical idea of the present second embodiment is also applicable to the SiC-IGBT having the gate pad similarly to the SiC-MOSFET, not limited to the SiC-MOSFET.

The invention made by the present inventers is specifically described on the basis of the appended claims.

The technical ideas of the aforementioned embodiments are applicable to, for example, an SiC hybrid module that the SiC-IGBT is combined with the SiC-diode (the SiC- Schottky barrier diode) and are also applicable to a full SiC module configured by the SiC-MOSFET and a full SiC module that the SiC-IGBT is combined with the SiC-diode. Further, the technical ideas of the aforementioned embodiments are also applicable to, for example, a technology of combining a semiconductor element using the wide band gap semiconductor material such as SiC, GaN, diamond and so forth with a semiconductor element using a semiconductor material which has a general band gap such as silicon, gallium arsenide, germanium and so forth. In addition, the technical ideas of the aforementioned embodiments are also applicable to a technology of combining semiconductor elements such as the Schottky barrier diode and the p-n junction diode, the MOSFET and a junction FET, the bipolar transistor, the IGBT and so forth with one another/each other.

### Reference Signs List

- ADE:: anode electrode
- CHP1:: semiconductor chip
- CNR1:: corner part
- CNR2:: corner part
- CP1:: cross-point
- CP2:: cross-point
- CRL1A:: curved-line part
- CRL1B:: curved-line part
- CRL2A:: curved-line part
- CRL2B:: curved-line part
- DGL1:: diagonal line
- DGL2:: diagonal line
- EG1:: end face
- EG2:: outer end part
- EG3:: inner end part
- GL:: silicone gel
- GP:: gate pad
- L1:: width
- L2:: width
- MR:: high electric field resistance sealing member
- SP:: source pad
- TMR:: termination part

## Claims

1. A semiconductor device comprising:
a semiconductor chip (CHP) which includes a semiconductor material which is larger than silicon in band gap,
wherein the semiconductor chip (CHP) has:
a peripheral edge part;
a semiconductor element formation part located on an inner side of the peripheral edge part; and
an insulating member (MR) which covers the peripheral edge part and surrounds the semiconductor element formation part, and
in a planar view, a shape of an inner end part (IEG) of the insulating member (MR) includes curved-line parts (CRL1A, CRL1B, CRL2A, CRL2B) which are mutually different in radius of curvature,
wherein in the planar view, the shape of the inner end part (IEG) of the insulating member (MR) includes:
one pair of first curved-line parts (CRL1A, CRL1B) having a first radius of curvature; and
one pair of second curved-line parts (CRL2A, CRL2B) having a second radius of curvature which is different from the first radius of curvature.

2. The semiconductor device according to claim 1,
wherein the semiconductor chip (CHP) is configured by a rectangular shape having a first diagonal line (DGL1) and a second diagonal line (DGL2),
each of the one pair of the first curved-line parts (CRL1A, CRL1B) intersects with the second diagonal line (DGL2), and
each of the one pair of the second curved-line parts (CRL2A, CRL2B) intersects with the first diagonal line (DGL1).

3. The semiconductor device according to claim 2,
wherein the second radius of curvature is smaller than the first radius of curvature, and
in a planar view, a plurality of connection parts (CU1, CU2, CU3) of the semiconductor chip (CHP) with each of a plurality of wires are disposed on the semiconductor element formation part which is exposed from the insulating member (MR) along the first diagonal line (DGL1).

4. The semiconductor device according to claim 1,
wherein the semiconductor chip (CHP) is configured by a rectangular shape having a first diagonal line (DGL1) and a second diagonal line (DGL2),
one first curved-line part in the one pair of the first curved-line parts (CRL1A, CRL1B) intersects with the first diagonal line (DGL1),
one second curved-line part in the one pair of the second curved-line parts (CRL2A, CRL2B) intersects with the first diagonal line (DGL1),
the other first curved-line part in the one pair of the first curved-line parts (CRL1A, CRL1B) intersects with the second diagonal line (DGL2), and
the other second curved-line part in the one pair of the second curved-line parts (CRL2A, CRL2B) intersects with the second diagonal line (DGL2).

5. The semiconductor device according to claim 4,
wherein a gate pad electrode (GP) of a power transistor is disposed on the semiconductor element formation part,
the second radius of curvature is smaller than the first radius of curvature, and
the gate pad electrode (GP) is disposed at a position closer to the one pair of the second curved-line parts (CRL2A, CRL2B) than to the one pair of the first curved-line parts (CRL1A, CRL1B).

6. The semiconductor device according to claim 1,
wherein the semiconductor chip (CHP) is configured by a rectangular shape having a first diagonal line (DGL1) and a second diagonal line (DGL2),
in a planar view, a shape of an inner end part (IEG) of the insulating member (MR) includes
a first curved-line part which has a first radius of curvature and intersects with the second diagonal line (DGL2) and
a second curved-line part (CRL2A) which has a second radius of curvature which is smaller than the first radius of curvature and intersects with the first diagonal line (DGL1), and
a first width (L1) of the insulating member (MR) which is a distance between a first corner part (CNR1) which is a one-end point of the first diagonal line (DGL1) and a first cross-point (CP1) of the second curved-line part (CRL2A) with the first diagonal line (DGL1) is smaller than a second width (L2) of the insulating member (MR) which is a distance between a second corner part (CNR2) which is a one-end point of the second diagonal line (DGL2) and a second cross-point (CP2) of the first curved-line part (CRL1A) with the second diagonal line (DGL2).

## Patentansprüche

1. Halbleitervorrichtung, umfassend:
einen Halbleiterchip (CHP), der ein Halbleitermaterial umfasst, dessen Bandlücke größer als jene von Silicium ist,
wobei der Halbleiterchip (CHP) Folgendes aufweist:
einen Umfangskantenteil;
einen Halbleiterelementausbildungsteil, der auf einer Innenseite des Umfangskantenteils angeordnet ist; und
einen Isolierteil (MR), der den Umfangskantenteil bedeckt und den Halbleiterelementausbildungsteil umgibt, und
wobei eine Form eines Innenendteils (IEG) des Isolierteils (MR) in einer Draufsicht gekrümmte-Linie-Teile (CRL1A, CRL1B, CRL2A, CRL2B) umfasst, die einen jeweils unterschiedlichen Krümmungsradius aufweisen,
wobei die Form des Innenendteils (IEG) des Isolierteils (MR) in der Draufsicht Folgendes umfasst:
ein Paar von ersten gekrümmte-Linie-Teilen (CRL1A, CRL1B), die einen ersten Krümmungsradius aufweisen; und
ein Paar von zweiten gekrümmte-Linie-Teilen (CRL2A, CRL2B), die einen zweiten Krümmungsradius aufweisen, der sich von dem ersten Krümmungsradius unterscheidet.

2. Halbleitervorrichtung nach Anspruch 1,
wobei der Halbleiterchip (CHP) durch eine rechteckige Form konfiguriert ist, die eine erste Diagonallinie (DGL1) und eine zweite Diagonallinie (DGL2) aufweist,
wobei jeder des einen Paars der ersten gekrümmte-Linie-Teile (CRL1A, CRL1B) sich mit der zweiten Diagonallinie (DGL2) überschneidet, und
wobei jeder des einen Paars der zweiten gekrümmte-Linie-Teile (CRL2A, CRL2B) sich mit der ersten Diagonallinie (DGL1) überschneidet.

3. Halbleitervorrichtung nach Anspruch 2,
wobei der zweite Krümmungsradius kleiner als der erste Krümmungsradius ist und
eine Vielzahl von Verbindungsteilen (CU1, CU2, CU3) des Halbleiterchips (CHP) in einer Draufsicht mit jedem einer Vielzahl von Drähten auf dem Halbleiterelementausbildungsteil angeordnet sind, der von dem Isolierteil (MR) entlang der ersten Diagonallinie (DGL1) freiliegt.

4. Halbleitervorrichtung nach Anspruch 1,
wobei der Halbleiterchip (CHP) durch eine rechteckige Form konfiguriert ist, die eine erste Diagonallinie (DGL1) und eine zweite Diagonallinie (DGL2) aufweist,
wobei ein erster gekrümmte-Linie-Teil in dem einen Paar der ersten gekrümmte-Linie-Teile (CRL1A, CRL1B) sich mit der ersten Diagonallinie (DGL1) überschneidet,
wobei ein zweiter gekrümmte-Linie-Teil in dem einen Paar der zweiten gekrümmte-Linie-Teile (CRL2A, CRL2B) sich mit der ersten Diagonallinie (DGL1) überschneidet,
wobei der andere erste gekrümmte-Linie-Teil in dem einen Paar der ersten gekrümmte-Linie-Teile (CRL1A, CRL1B) sich mit der zweiten Diagonallinie (DGL2) überschneidet und
wobei der andere zweite gekrümmte-Linie-Teil in dem einen Paar der zweiten gekrümmte-Linie-Teile (CRL2A, CRL2B) sich mit der zweiten Diagonallinie (DGL2) überschneidet.

5. Halbleitervorrichtung nach Anspruch 4,
wobei eine Kontaktflächenelektrode (GP) eines Leistungstransistors auf dem Halbleiterelementausbildungsteil angeordnet ist,
wobei der zweite Krümmungsradius kleiner als der erste Krümmungsradius ist und
wobei die Kontaktflächenelektrode (GP) an einer Position angeordnet ist, die sich näher an dem einen Paar der zweiten gekrümmte-Linie-Teile (CRL2A, CRL2B) als an dem einen Paar der ersten gekrümmte-Linie-Teile (CRL1A, CRL1B) befindet.

6. Halbleitervorrichtung nach Anspruch 1,
wobei der Halbleiterchip (CHP) durch eine rechteckige Form konfiguriert ist, die eine erste Diagonallinie (DGL1) und eine zweite Diagonallinie (DGL2) aufweist,
wobei eine Form eines Innenendteils (IEG) des Isolierteils (MR) in einer Draufsicht Folgendes umfasst:
einen ersten gekrümmte-Linie-Teil, der einen ersten Krümmungsradius aufweist und sich mit der zweiten Diagonallinie (DGL2) überschneidet, und
einen zweiten gekrümmte-Linie-Teil (CRL2A), der einen zweiten Krümmungsradius aufweist, der kleiner als der erste Krümmungsradius ist, und sich mit der ersten Diagonallinie (DGL1) überschneidet, und
wobei eine erste Breite (L1) des Isolierteils (MR), die ein Abstand zwischen einem ersten Eckteil (CNR1), der ein Endpunkt der ersten Diagonallinie (DGL1) ist, und einem ersten Kreuzungspunkt (CP1) des zweiten gekrümmte-Linie-Teils (CRL2A) mit der ersten Diagonallinie (DGL1) ist, kleiner als eine zweite Breite (L2) des Isolierteils (MR) ist, die ein Abstand zwischen einem zweiten Eckteil (CNR2), der ein Endpunkt der zweiten Diagonallinie (DGL2) ist, und einem zweiten Kreuzungspunkt (CP2) des ersten gekrümmte-Linie-Teils (CRL1A) mit der zweiten Diagonallinie (DGL2) ist.

## Revendications

1. Dispositif à semi-conducteur comprenant :
une puce à semi-conducteur(CHP) qui comprend un matériau semi-conducteur présentant une bande interdite plus importante que celle du silicium,
dans lequel la puce à semi-conducteur(CHP) a :
une partie de bord périphérique ;
une partie de formation d'élément semi-conducteur située sur un côté interne de la partie de bord périphérique ; et
un élément isolant (MR) qui recouvre la partie de bord périphérique et entoure la partie de formation d'élément semi-conducteur, et
dans une vue en plan, une forme d'une partie d'extrémité interne (IEG) de l'élément isolant (MR) comprend des parties de ligne courbe (CRL1A, CRL1B, CRL2A, CRL2B) qui sont mutuellement différentes en terme de rayon de courbure,
dans lequel, dans la vue en plan, la forme de la partie d'extrémité interne (IEG) de l'élément isolant (MR) comprend :
une paire de premières parties de ligne courbe (CRL1A, CRL1B) ayant un premier rayon de courbure ; et
une paire de secondes parties de ligne courbe (CRL2A, CRL2B) ayant un second rayon de courbure qui est différent du premier rayon de courbure.

2. Dispositif à semi-conducteur selon la revendication 1,
dans lequel la puce à semi-conducteur (CHP) est configurée par une forme rectangulaire ayant une première ligne diagonale (DGL1) et une seconde ligne diagonale (DGL2),
chacune de la paire des premières parties de ligne courbe (CRL1A, CRL1B) recoupe la seconde ligne diagonale (DGL2), et
chacune de la paire des secondes parties de ligne courbe (CRL2A, CRL2B) recoupe la première ligne diagonale (DGL1).

3. Dispositif à semi-conducteur selon la revendication 2,
dans lequel le second rayon de courbure est plus petit que le premier rayon de courbure, et
dans une vue en plan, une pluralité de parties de connexion (CU1, CU2, CU3) de la puce à semi-conducteur (CHP) avec chacun d'une pluralité de fils sont disposées sur la partie de formation d'élément semi-conducteur qui est exposée à partir de l'élément isolant (MR) le long de la première ligne diagonale (DGL1).

4. Dispositif à semi-conducteur selon la revendication 1,
dans lequel la puce à semi-conducteur (CHP) est configurée par une forme rectangulaire ayant une première ligne diagonale (DGL1) et une seconde ligne diagonale (DGL2),
une première partie de ligne courbe dans la paire de premières parties de ligne courbe (CRL1A, CRL1B) recoupe la première ligne diagonale (DGL1),
une seconde partie de ligne courbe dans la paire des secondes parties de ligne courbe (CRL2A, CRL2B) recoupe la première ligne diagonale (DGL1),
l'autre première partie de ligne courbe dans la paire des premières parties de ligne courbe (CRL1A, CRL1B) recoupe la seconde ligne diagonale (DGL2), et
l'autre seconde partie de ligne courbe dans la paire des secondes parties de ligne courbe (CRL2A, CRL2B) recoupe la seconde ligne diagonale (DGL2).

5. Dispositif à semi-conducteur selon la revendication 4,
dans lequel une électrode de pastille de grille (GP) d'un transistor de puissance est disposée sur la partie de formation d'élément semi-conducteur,
le second rayon de courbure est plus petit que le premier rayon de courbure, et
l'électrode de pastille de grille (GP) est disposée dans une position plus proche de la paire des secondes parties de ligne courbe (CRL2A, CRL2B) que de la paire des premières parties de ligne courbe (CRL1A, CRL1B).

6. Dispositif à semi-conducteur selon la revendication 1,
dans lequel la puce à semi-conducteur (CHP) est configurée par une forme rectangulaire ayant une première ligne diagonale (DGL1) et une seconde ligne diagonale (DGL2),
dans une vue en plan, une forme d'une partie d'extrémité interne (IEG) de l'élément isolant (MR) comprend
une première partie de ligne courbe qui a un premier rayon de courbure et recoupe la seconde ligne diagonale (DGL2) et
une seconde partie de ligne courbe (CRL2A) qui a un second rayon de courbure qui est plus petit que le premier rayon de courbure et recoupe la première ligne diagonale (DGL1), et
une première largeur (L1) de l'élément isolant (MR) qui est une distance entre une première partie d'angle (CNR1) qui est un point d'extrémité de la première ligne diagonale (DGL1) et un premier point de croisement (CP1) de la seconde partie de ligne courbe (CRL2A) avec la première ligne diagonale (DGL1) est plus petite qu'une seconde largeur (L2) de l'élément isolant (MR) qui est une distance entre une seconde partie d'angle (CNR2) qui est un point d'extrémité de la seconde ligne diagonale (DGL2) et un second point de croisement (CP2) de la première partie de ligne courbe (CRL1A) avec la seconde ligne diagonale (DGL2).
